(19)

Europäisches
Patentamt
European
Patent Office
Office européen
des brevets

(11) **EP 4 462 184 A1**

(12) # EUROPEAN PATENT APPLICATION

(43) Date of publication:
**13.11.2024  Bulletin 2024/46**

(21) Application number: **23212911.4**

(22) Date of filing: **29.11.2023**

(51) International Patent Classification (IPC):
**G03B 9/06** *(2021.01)*       **G02B 5/00** *(2006.01)*
**G03B 30/00** *(2021.01)*

(52) Cooperative Patent Classification (CPC):
**G03B 9/06; G03B 30/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **12.05.2023  US 202363466178 P**

(71) Applicant: **Largan Precision Co. Ltd.**
**Taichung City, R.O.C. (TW)**

(72) Inventors:
• **HONG, ZHENG-ZHI**
  **R.O.C. Taichung City (TW)**

• **SU, HENG YI**
  **R.O.C. Taichung City (TW)**
• **TSENG, YI HUA**
  **R.O.C. Taichung City (TW)**
• **TSENG, Te-Sheng**
  **R.O.C. Taichung City (TW)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54)  **ADJUSTABLE APERTURE MODULE, IMAGING LENS MODULE, CAMERA MODULE AND ELECTRONIC DEVICE**

(57)     An adjustable aperture module (1) includes a blade assembly (11), a fixed component (12) connected to the blade assembly (11), a movable component (13) connected to the blade assembly (11), and a driving mechanism (17). The blade assembly (11) includes light-blocking blades (111) overlapping one another in a circumferential direction (D1) surrounding a central axis (CL) and together forming a light pass aperture (LPH). The movable component (13) is disposed corresponding to the fixed component (12). The driving mechanism (17) is configured to rotate the movable component (13) in the circumferential direction (D1) relative to the fixed component (12). The driving mechanism (17) includes at least one coil assembly (171) and at least one magnet (173) arranged along the circumferential direction (D1). The coil assembly (171) includes at least two coils (1710). The magnet (173) is disposed on the movable component (13) and includes at least one magnetic pole (MP). The magnetic pole (MP) is disposed corresponding to the coil assembly (171) and facing at least two coils (1710) of the coil assembly (171).

FIG. 2

EP 4 462 184 A1

## Description

## BACKGROUND

Technical Field

The present disclosure relates to an adjustable aperture module, an imaging lens module, a camera module and an electronic device, more particularly to an adjustable aperture module, an imaging lens module and a camera module applicable to an electronic device.

Description of Related Art

With the development of semiconductor manufacturing technology, the performance of image sensors has been improved, and the pixel size thereof has been scaled down. Therefore, featuring high image quality becomes one of the indispensable features of an optical system nowadays. Furthermore, due to the rapid changes in technology, electronic devices equipped with optical systems are trending towards multi-functionality for various applications, and therefore the functionality requirements for the optical systems have been increasing.

In recent years, compact camera modules have been applied in various fields, such as portable devices (e.g., smartphones, action cameras), augmented reality and virtual reality head-mounted devices or aerial cameras. Moreover, the hardwares of the compact camera modules has been continuously upgraded, such as larger image sensors and imaging lenses with higher image quality. However, using larger image sensors can provide users with better image quality but may result in background blurring. A conventional adjustable aperture module can be used to adjust the degree of background blurring and control the amount of light entering the imaging lens. However, due to size limitations, it is difficult for the camera modules to be equipped with adjustable aperture modules. Specifically, existing designs of the conventional adjustable aperture modules encounter several issues when applied to compact camera modules. These issues include susceptibility to damage for downsized aperture blades, excessive weight, inability to meet precision requirements (such as aperture size and positioning accuracy of light pass aperture), and difficulty in balancing miniaturization and adequate magnetic driving force.

## SUMMARY

According to one aspect of the present disclosure, an adjustable aperture module includes a blade assembly, a fixed component, a movable component and a driving mechanism. The blade assembly includes at least two light-blocking blades overlapping one another in a circumferential direction surrounding a central axis of the adjustable aperture module and together forming a light pass aperture, and an aperture size of the light pass aperture is adjustable. The fixed component is connected to the blade assembly. The movable component is connected to the blade assembly and disposed corresponding to the fixed component. The driving mechanism is configured to rotate the movable component in the circumferential direction relative to the fixed component so as to move the blade assembly for adjusting the aperture size of the light pass aperture. Preferably, the driving mechanism includes at least one coil assembly and at least one magnet. The at least one coil assembly includes at least two coils. The at least one magnet is disposed on the movable component, and the at least one magnet includes at least one magnetic pole. The at least one magnetic pole is disposed corresponding to the at least on coil assembly and faces at least two coils of the at least one coil assembly. The at least one coil assembly is arranged along the circumferential direction, and the magnet is arranged along the circumferential direction. In addition, when a length of each of the at least one magnet in the circumferential direction is Lm, and a radial thickness of each of the at least one magnet is Tm, the following condition is preferably satisfied: $1.5 < Lm/Tm < 80$.

According to another aspect of the present disclosure, an adjustable aperture module includes a blade assembly, a fixed component, a movable component, a driving mechanism and at least one Hall sensor. The blade assembly includes at least two light-blocking blades overlapping one another in a circumferential direction surrounding a central axis of the adjustable aperture module and together forming a light pass aperture, and an aperture size of the light pass aperture is adjustable. The fixed component is connected to the blade assembly. The movable component is connected to the blade assembly and disposed corresponding to the fixed component. The driving mechanism is configured to rotate the movable component in the circumferential direction relative to the fixed component so as to move the blade assembly for adjusting the aperture size of the light pass aperture. Preferably, the driving mechanism includes at least one coil assembly and at least one magnet. The at least one coil assembly includes at least two coils. The at least one magnet disposed on the movable component. The at least one magnet includes at least two magnetic poles, and the at least two magnetic poles includes a first magnetic pole and a second magnetic pole. The first magnetic pole is disposed corresponding to the at least one coil assembly and faces two coils of the at least one coil assembly, and the second magnetic pole is disposed corresponding to the at least one coil assembly and faces one coil of the at least one coil assembly. The at least one Hall sensor faces the second magnetic pole and configured to detect changes in a magnetic field around the second magnetic pole. The at least one coil assembly is arranged along the circumferential direction, the at least one magnet is arranged along the circumferential direction, and the at least one Hall sensor is arranged along the circumferential direction. In addition, a length of each of the at least one magnet in the circumferential direction is Lm, and a radial thickness of each of the at least one magnet is Tm, the following condition is preferably satisfied: $1.5 < Lm/Tm < 80$.

According to another aspect of the present disclosure, an imaging lens module includes one of the aforementioned adjustable aperture modules and an imaging lens. The adjustable aperture module is disposed on an optical axis of the imaging lens, and the adjustable aperture module and the imaging lens are arranged along the optical axis.

According to another aspect of the present disclosure, a camera module includes the aforementioned imaging lens module and an image sensor. The image sensor is disposed on an image surface of the imaging lens module.

According to another aspect of the present disclosure, an electronic device includes the aforementioned camera module.

## BRIEF DESCRIPTION OF THE DRAWINGS

The disclosure can be better understood by reading the following detailed description of the embodiments, with reference made to the accompanying drawings as follows:

Fig. 1 is a perspective view of an adjustable aperture module according to the 1st embodiment of the present disclosure;
Fig. 2 is an exploded view of the adjustable aperture module in Fig. 1;
Fig. 3 is another exploded view of the adjustable aperture module in Fig. 1;
Fig. 4 shows a perspective view of a driving mechanism, a Hall sensor and a flexible printed circuit of the adjustable aperture module in Fig. 1, as well as a partially enlarged view of the perspective view;
Fig. 5 is a top view of the driving mechanism, the Hall sensor and the flexible printed circuit of the adjustable aperture module in Fig. 1;
Fig. 6 is a top view of the flexible printed circuit, the Hall sensor and coil assemblies of a driving mechanism of the adjustable aperture module in Fig. 1;
Fig. 7 shows a side view of the driving mechanism, the Hall sensor and the flexible printed circuit of the adjustable aperture module in Fig. 1, as well as a partially enlarged view of the side view;
Fig. 8 is a perspective view of a driving mechanism, a Hall sensor and a flexible printed circuit according to another embodiment of the present disclosure;
Fig. 9 is a top view of the driving mechanism, the Hall sensor and the flexible printed circuit in Fig. 8;
Fig. 10 is a top view of coil assemblies of the driving mechanism, the Hall sensor and the flexible printed circuit in Fig. 8;
Fig. 11 is a perspective view of a driving mechanism, a Hall sensor and a flexible printed circuit according to another embodiment of the present disclosure;

Fig. 12 is a top view of the driving mechanism, the Hall sensor and the flexible printed circuit in Fig. 11;
Fig. 13 is a top view of coil assemblies of the driving mechanism, the Hall sensor and the flexible printed circuit in Fig. 11;
Fig. 14 is a perspective view of a driving mechanism, a Hall sensor and a flexible printed circuit according to another embodiment of the present disclosure;
Fig. 15 is a top view of the driving mechanism, the Hall sensor and the flexible printed circuit in Fig. 14;
Fig. 16 is a top view of a coil assembly of the driving mechanism, the Hall sensor and the flexible printed circuit in Fig. 14;
Fig. 17 is a perspective view of an adjustable aperture module according to the 2nd embodiment of the present disclosure;
Fig. 18 is an exploded view of the adjustable aperture module in Fig. 17;
Fig. 19 is another exploded view of the adjustable aperture module in Fig. 17;
Fig. 20 shows a perspective view of a driving mechanism, a Hall sensor and a flexible printed circuit of the adjustable aperture module in Fig. 17, as well as a partially enlarged view of the perspective view;
Fig. 21 is a top view of the driving mechanism, the Hall sensor and the flexible printed circuit of the adjustable aperture module in Fig. 17;
Fig. 22 is a top view of the flexible printed circuit, the Hall sensor and coil assemblies of a driving mechanism of the adjustable aperture module in Fig. 17;
Fig. 23 shows a side view of the driving mechanism, the Hall sensor and the flexible printed circuit of the adjustable aperture module in Fig. 17, as well as a partially enlarged view of the side view;
Fig. 24 is a perspective view of a driving mechanism, Hall sensors and a flexible printed circuit according to another embodiment of the present disclosure;
Fig. 25 is a top view of the driving mechanism, the Hall sensors and the flexible printed circuit in Fig. 24;
Fig. 26 is a top view of coil assemblies of the driving mechanism, the Hall sensors and the flexible printed circuit in Fig. 24;
Fig. 27 is a perspective view of a driving mechanism, Hall sensors and a flexible printed circuit according to another embodiment of the present disclosure;
Fig. 28 is a top view of the driving mechanism, the Hall sensors and the flexible printed circuit in Fig. 27;
Fig. 29 is a top view of coil assemblies of the driving mechanism, the Hall sensors and the flexible printed circuit in Fig. 27;
Fig. 30 is a perspective view of a driving mechanism, a Hall sensor and a flexible printed circuit according to another embodiment of the present disclosure;
Fig. 31 is a top view of the driving mechanism, the Hall sensor and the flexible printed circuit in Fig. 30;
Fig. 32 is a top view of a coil assembly of the driving mechanism, the Hall sensor and the flexible printed circuit in Fig. 30;

Fig. 33 is a perspective view of a driving mechanism, a Hall sensor and a flexible printed circuit according to another embodiment of the present disclosure;
Fig. 34 is a top view of the driving mechanism, the Hall sensor and the flexible printed circuit in Fig. 33;
Fig. 35 is a top view of coil assemblies of the driving mechanism, the Hall sensor and the flexible printed circuit in Fig. 33;
Fig. 36 is a perspective view of a driving mechanism, a Hall sensor and a flexible printed circuit according to another embodiment of the present disclosure;
Fig. 37 is a top view of the driving mechanism, the Hall sensor and the flexible printed circuit in Fig. 36;
Fig. 38 is a top view of coil assemblies of the driving mechanism, the Hall sensor and the flexible printed circuit in Fig. 36;
Fig. 39 is a perspective view of a driving mechanism, a Hall sensor and a flexible printed circuit according to another embodiment of the present disclosure;
Fig. 40 is a top view of the driving mechanism, the Hall sensor and the flexible printed circuit in Fig. 39;
Fig. 41 is a top view of a coil assembly of the driving mechanism, the Hall sensor and the flexible printed circuit in Fig. 39;
Fig. 42 is a perspective view of a driving mechanism, a Hall sensor and a flexible printed circuit according to another embodiment of the present disclosure;
Fig. 43 is a top view of the driving mechanism, the Hall sensor and the flexible printed circuit in Fig. 42;
Fig. 44 is a top view of coil assemblies of the driving mechanism, the Hall sensor and the flexible printed circuit in Fig. 42;
Fig. 45 is a perspective view of a driving mechanism, a Hall sensor and a flexible printed circuit according to another embodiment of the present disclosure;
Fig. 46 is a top view of the driving mechanism, the Hall sensor and the flexible printed circuit in Fig. 45;
Fig. 47 is a top view of coil assemblies of the driving mechanism, the Hall sensor and the flexible printed circuit in Fig. 45;
Fig. 48 is one perspective view of an electronic device according to the 3rd embodiment of the present disclosure;
Fig. 49 is another perspective view of the electronic device in Fig. 48;
Fig. 50 is a block diagram of the electronic device in Fig. 48;
Fig. 51 shows an image captured by the electronic device using a wide-angle compact camera module in Fig. 48;
Fig. 52 shows an image captured by the electronic device using a camera module having an adjustable aperture module in Fig. 48 with an F-number of 1.4; and
Fig. 53 shows an image captured by the electronic device using a camera module having an adjustable aperture module in Fig. 48 with an F-number of 5.6.

## DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

The present disclosure provides an adjustable aperture module. The adjustable aperture module includes a blade assembly, a fixed component, a movable component and a driving mechanism. The blade assembly includes at least two light-blocking blades, and the light-blocking blades overlap one another in a circumferential direction surrounding a central axis of the adjustable aperture module and together form a light pass aperture. An aperture size of the light pass aperture is adjustable. The fixed component is connected to the blade assembly. The movable component is connected to the blade assembly and disposed corresponding to the fixed component. The driving mechanism is configured to rotate the movable component in the circumferential direction relative to the fixed component so as to move the blade assembly for adjusting the aperture size of the light pass aperture.

In one configuration, the driving mechanism includes at least one coil assembly and at least one magnet. The coil assembly includes at least two coils. The magnet is disposed on the movable component, and the magnet includes at least one magnetic pole. The at least one magnetic pole is disposed corresponding to the coil assembly and faces at least two coils of the coil assembly. The coil assembly is arranged along the circumferential direction, and the magnet is arranged along the circumferential direction.

In another configuration, the adjustable aperture module can further include at least one Hall sensor, and the driving mechanism includes at least one coil assembly and at least one magnet. The coil assembly includes at least two coils. The magnet is disposed on the movable component. The magnet includes at least two magnetic poles, and the at least two magnetic poles includes a first magnetic pole and a second magnetic pole. In addition, the first magnetic pole is disposed corresponding to the coil assembly and faces both of two coils of the coil assembly, and the second magnetic pole is disposed corresponding to the coil assembly and faces one coil of the coil assembly. In addition, the Hall sensor faces the second magnetic pole and is configured to detect changes in the magnetic field around the second magnetic pole. The coil assembly is arranged along the circumferential direction, the magnet is arranged along the circumferential direction, and the Hall sensor is arranged along the circumferential direction.

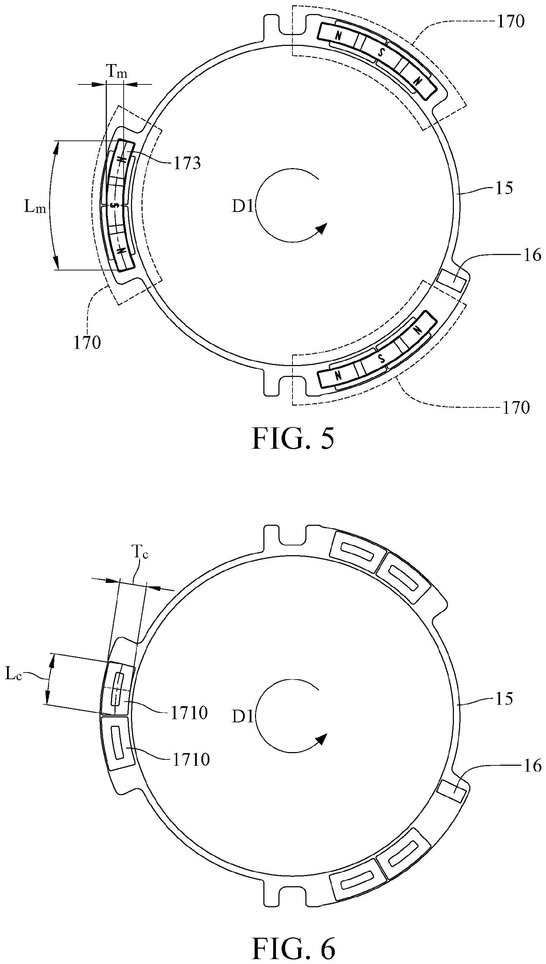

According to the present disclosure, by aligning multiple coils to face towards a single magnetic pole or aligning multiple magnetic poles to face towards a coil assembly, the spatial utilization efficiency of the adjustable aperture module can be improved, thereby achieving miniaturization of the module while also maintaining sufficient magnetic driving force. In addition, when a length of each magnet in the circumferential direction is Lm, and a radial thickness of each magnet is Tm, the following condition is satisfied: $1.5 < Lm/Tm < 80$. Said radial thickness of each magnet refers to a thickness of the magnet traversed by a reference line on a plane that is perpendicular to the central axis of the adjustable aperture module, with the reference line passing through a center on the plane defined by the central axis. Please refer to Fig. 5, which shows a length Lm of one magnet in the circumferential direction and a radial thickness Tm of the magnet according to the 1st embodiment of the present disclosure. In addition, the magnet(s) can extend or be arranged in the circumferential direction, and the magnet(s) can be in a wide and flat shape.

When a length of each of the coils in the circumferential direction is Lc, and a radial thickness of each of the coils is Tc, the following condition can be satisfied: $1 < Lc/Tc < 15$. Said radial thickness of each coil refers to a thickness of the coil traversed by a reference line on a plane that is perpendicular to the central axis of the adjustable aperture module, with the reference line passing through a center on the plane defined by the central axis. Please refer to Fig. 6, which shows a length Lc of one coil in the circumferential direction and a radial thickness Tc of the coil according to the 1st embodiment of the present disclosure. In addition, the coil(s) can extend or be arranged in the circumferential direction, and the coil(s) can be in a wide and flat shape.

The driving mechanism can further include at least one driving unit, and each of the at least one driving unit includes one of the at least one coil assembly and one of the at least one magnet. In addition, when the at least one driving unit includes multiple driving units, it allows for a more even distribution of the magnetic driving force generated by the driving mechanism, thereby improving the operational quality of the module. In addition, when a number of driving units is Nd, the following condition can be satisfied: $0 < Nd < 20$. Therefore, it is favorable for balancing between the even distribution of the magnetic driving force and preventing the magnetic driving force from becoming too weak, and it is an optimal quantity setting range. In addition, the following condition can also be satisfied: $1 < Nd < 20$.

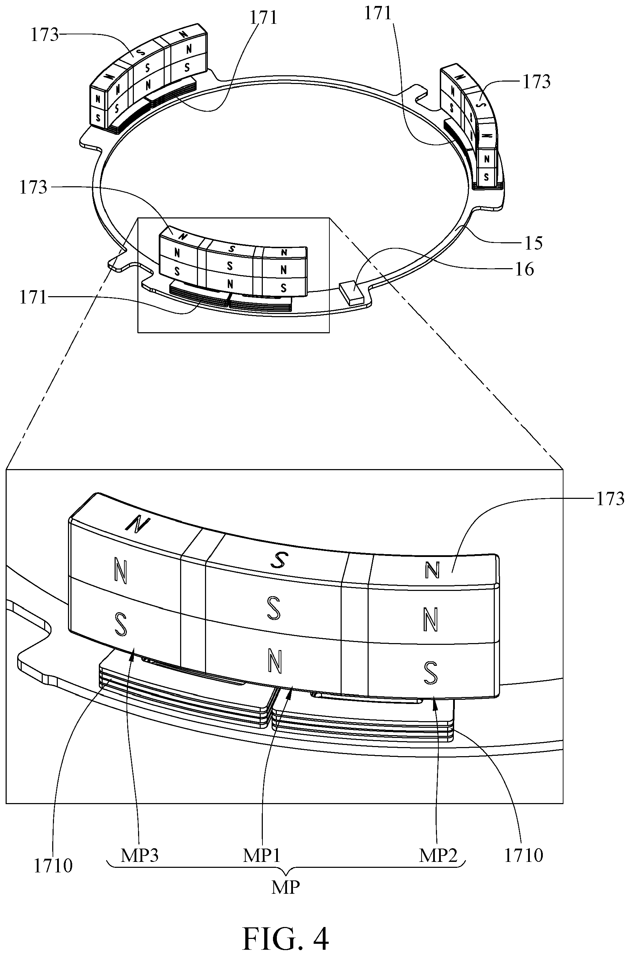

When a number of coils facing the at least one magnet in the at least one coil assembly is Nc, and a number of magnetic poles facing the at least one coil assembly among the at least one magnet is Nm, the following condition can be satisfied: $Nc + Nm \geq 5$. Therefore, it is favorable for the driving mechanism to have a better configuration of coils and magnetic poles for improved magnetic driving force. The magnets can be, for example, a sectorial-shaped integrated magnet or a square-shaped magnet, but the present disclosure is not limited thereto. Said the number Nm of magnetic poles facing the at least one coil assembly among the at least one magnet refers to, for example, a sum of magnetic poles on one side of the sectorial-shaped integrated magnet or the square-shaped magnet facing the coil assembly, but the present disclosure is not limited thereto. For example, when $Nc = 2$ and $Nm = 3$, there are three magnetic poles facing two coils, as one of the driving units exemplarily shown in Fig. 4, but the present disclosure is not limited thereto.

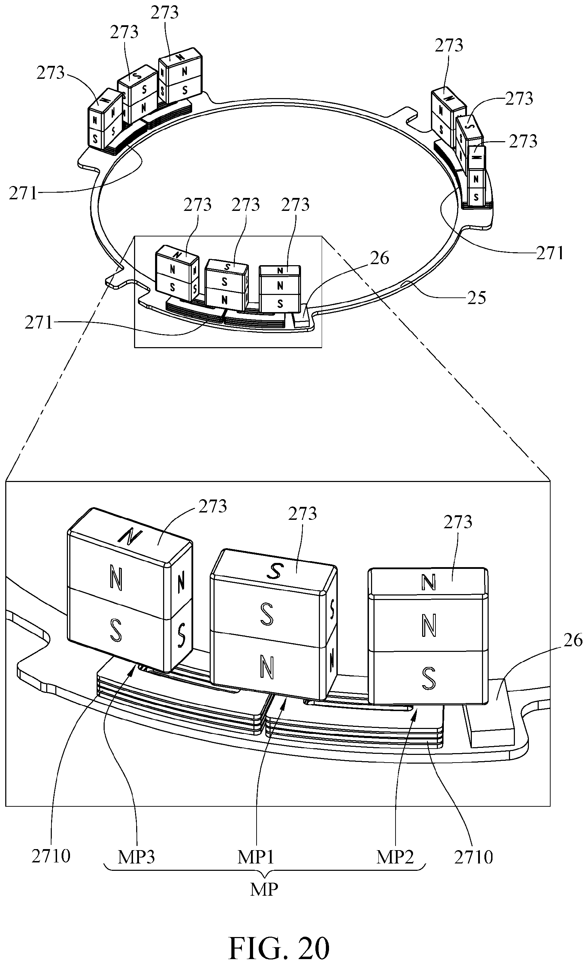

When the number of coils facing the at least one magnet in the at least one coil assembly is Nc, the number of magnetic poles facing the at least one coil assembly among the at least one magnet is Nm, and a number of the at least one Hall sensor is Nh, the following condition can be satisfied: $Nc + Nm + Nh \geq 6$. Therefore, it is favorable for the driving mechanism to have a better configuration of coils and magnetic poles for improved magnetic driving force. For example, when $Nc = 2$, $Nm = 3$ and $Nh = 1$, there are three magnetic poles facing two coils and one Hall sensor, as one of the driving units exemplarily shown in Fig. 20, but the present disclosure is not limited thereto.

The movable component can further include a mounting structure, and the magnet is disposed on the mounting structure. Therefore, it is favorable for improving the stability of magnet installation. In addition, the mounting structure ensures no relative movement occurs between the magnet and the movable component.

The adjustable aperture module can further include a flexible printed circuit, and the coil assembly of the driving mechanism is disposed on the flexible printed circuit. In addition, the Hall sensor is located on one side of the coil assembly in the circumferential direction and disposed on the flexible printed circuit. Therefore, it is favorable for the Hall sensor to accurately determine the position of the movable component.

One of the magnetic poles of the magnet can face two of the coils of the coil assembly. Therefore, aligning multiple coils to face towards a single magnetic pole is favorable for increasing the magnetic driving force generated by the driving mechanism.

Another of the magnetic poles of the magnet can face both of the Hall sensor and one of the coils of the coil assembly located closest to the Hall sensor. Therefore, by the arrangement of the coil and magnetic pole, the Hall sensor can achieve better detection efficiency. In addition, by using the Hall sensor to detect changes in the magnetic field around the magnetic pole to which the Hall sensor faces, the displacement of the movable component along the circumferential direction can be determined. This information is then fed back to the driving mechanism to adjust the aperture size of the light pass aperture.

According to the present disclosure, an imaging lens module is provided. The imaging lens module includes the aforementioned adjustable aperture module and an imaging lens. The adjustable aperture module is disposed on an optical axis of the imaging lens, and the adjustable aperture module and the imaging lens are arranged along the optical axis.

According to the present disclosure, a camera module is provided. The camera module includes the aforementioned imaging lens module and an image sensor. The image sensor is disposed on an image surface of the imaging lens module.

According to the present disclosure, an electronic device is provided. The electronic device includes the aforementioned camera module.

According to the present disclosure, the aforementioned features and conditions can be utilized in numerous combinations so as to achieve corresponding effects.

According to the above description of the present disclosure, the following specific embodiments are provided for further explanation.

**1st Embodiment**

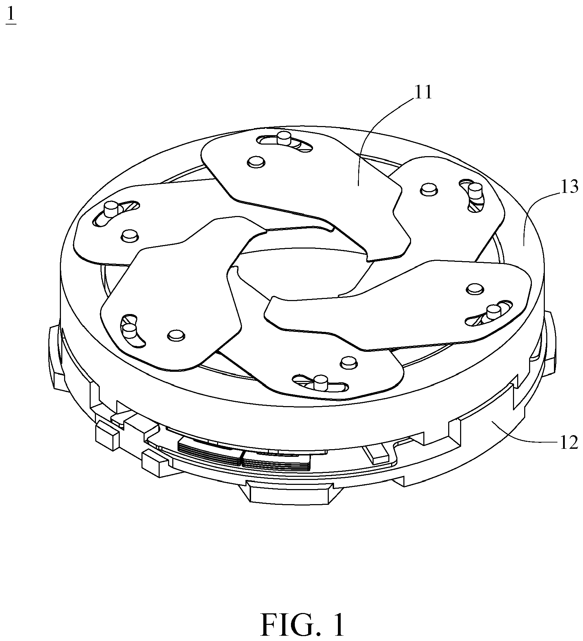

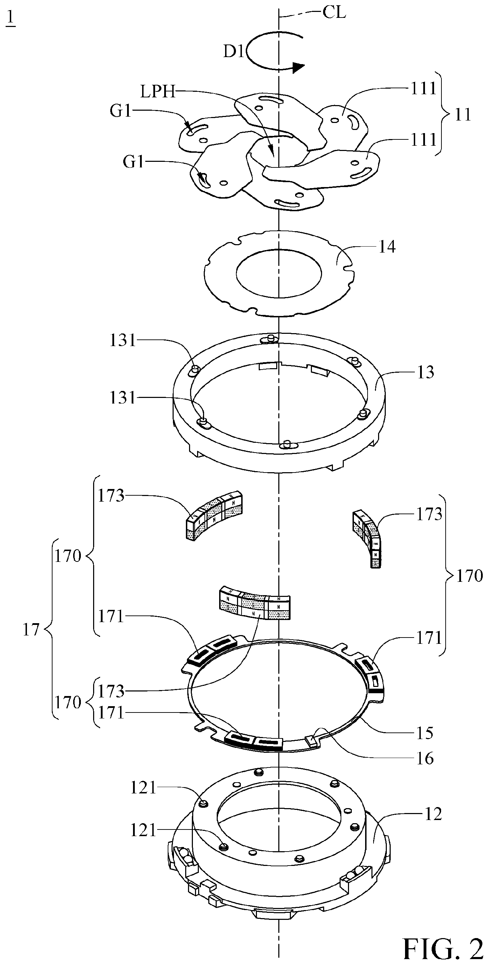

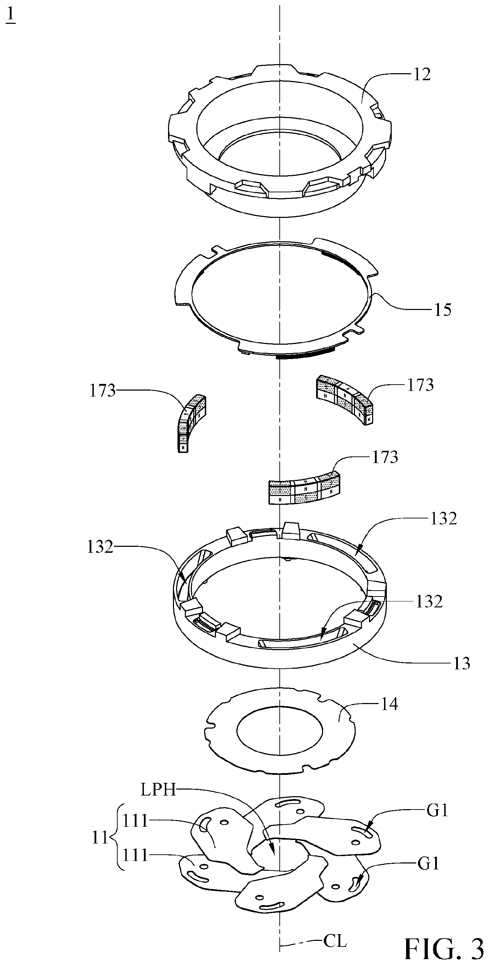

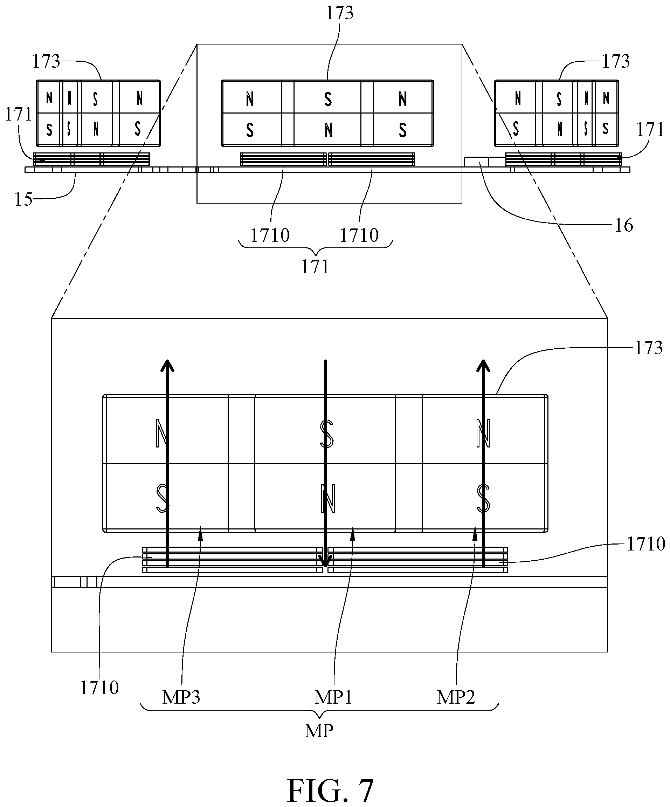

Fig. 1 is a perspective view of an adjustable aperture module according to the 1st embodiment of the present disclosure, Fig. 2 is an exploded view of the adjustable aperture module in Fig. 1, Fig. 3 is another exploded view of the adjustable aperture module in Fig. 1, Fig. 4 shows a perspective view of a driving mechanism, a Hall sensor and a flexible printed circuit of the adjustable aperture module in Fig. 1, as well as a partially enlarged view of the perspective view, Fig. 5 is a top view of the driving mechanism, the Hall sensor and the flexible printed circuit of the adjustable aperture module in Fig. 1, Fig. 6 is a top view of the flexible printed circuit, the Hall sensor and coil assemblies of a driving mechanism of the adjustable aperture module in Fig. 1, and Fig. 7 shows a side view of the driving mechanism, the Hall sensor and the flexible printed circuit of the adjustable aperture module in Fig. 1, as well as a partially enlarged view of the side view.

In this embodiment, an adjustable aperture module 1 includes a blade assembly 11, a fixed component 12, a movable component 13, a fixed aperture component 14, a flexible printed circuit 15, a Hall sensor 16 and a driving mechanism 17.

The blade assembly 11 includes six light-blocking blades 111 overlapping one another in a circumferential direction D1 surrounding a central axis CL of the adjustable aperture module 1 and together form a light pass aperture LPH. In addition, an aperture size of the light pass aperture LPH is adjustable.

The fixed component 12 is connected to the blade assembly 11. In specific, the light-blocking blades 111 of the blade assembly 11 are rotatably disposed on six shaft structures 121 of the fixed component 12, respectively, such that each of the light-blocking blades 111 of the blade assembly 11 is pivotable relative to the fixed component 12.

The movable component 13 is connected to the blade assembly 11 and disposed corresponding to the fixed component 12. In specific, six connection protrusions 131 of the movable component 13 are slidably disposed in grooves G1 of the light-blocking blades 111, respectively, such that when the driving mechanism 17 rotates the movable component 13 in the circumferential direction D1 relative to the fixed component 12, the movable component 13 drives the light-blocking blades 111 of the blade assembly 11 to pivot relative to the fixed component 12 so as to adjust the aperture size of the light pass aperture LPH.

The fixed aperture component 14 is disposed on the fixed component 12, and the fixed aperture component 14 is disposed corresponding to the light-blocking blades 111 so as to define a fixed F-number. Furthermore, the fixed aperture component 14 is located close to the blade assembly 11 and coaxially arranged with the blade assembly 11.

The flexible printed circuit 15 is attached to the fixed component 12, and the Hall sensor 16 is disposed on the flexible printed circuit 15.

The driving mechanism 17 includes three driving units 170, and each of the driving units 170 includes a coil assembly 171 and a magnet 173 that are disposed corresponding to each other. The coil assemblies 171 are disposed on the flexible printed circuit 15 and arranged along the circumferential direction D1, and the magnets 173 are disposed on the movable component 13 and arranged along the circumferential direction D1. In addition, the movable component 13 includes three mounting structures 132, and the magnets 173 of the driving units 170 are disposed in the mounting structures 132, respectively. In this embodiment, each of the magnets 173 is a sectorial-shaped integrated magnet, and the mounting structures 132 are recesses configured to receive the magnets 173.

Each of the coil assemblies 171 includes two coils 1710 that are arranged along the circumferential direction D1, and each of the magnets 173 includes a plurality of magnetic poles MP that are arranged along the circumferential direction D1. In detail, from the perspective of one of the driving units 170, the magnet 173 includes three magnetic poles MP disposed corresponding to the coil assembly 171 and facing the coil assembly 171. The three magnetic poles MP include a first magnetic pole MP1, a second magnetic pole MP2 and a third magnetic pole MP3. The first magnetic pole MP1 faces the two coils 1710 of the coil assembly 171, the second magnetic pole MP2 faces one of the coils 1710 of the coil assembly 171, and the third magnetic pole MP3 also faces one of the coils 1710 of the coil assembly 171. Fig. 7 shows multiple arrows passing through one of the magnets 173 to represent the direction of the magnetic field lines of the magnet 173. However, it should be noted that the configuration of North (N) and South (S) poles, as well as the direction of the magnetic field lines, is not limited to that as shown in Fig. 7. In some other configurations, the magnet can be configured with two N poles and one S pole facing the coil assembly, and the S pole is located between the N poles. Additionally, the arrows representing the direction of the magnetic field lines of the magnet can have the arrows on the sides pointing towards the coil assembly, and the arrow in the middle points away from the coil assembly.

In this embodiment, the Hall sensor 16 is located adjacent to one of the coil assemblies 171 and located on one side of the coil assembly 171 in the circumferential direction D1.

When a length of each of the magnets 173 in the circumferential direction D1 is Lm, and a radial thickness of each of the magnets 173 is Tm, the following conditions are satisfied: Lm = 3.98 mm; Tm = 0.52 mm; and Lm/Tm = 7.7.

When a length of each of the coils 1710 in the circumferential direction D1 is Lc, and a radial thickness of each of the coils 1710 is Tc, the following conditions are satisfied: Lc = 1.55 mm; Tc = 0.8 mm; and Lc/Tc = 1.9.

When a number of the driving units 170 is Nd, the following condition is satisfied: Nd = 3.

When a number of coils facing the magnets 173 in the coil assemblies 171 is Nc, and a number of magnetic poles facing the coil assemblies 171 among the magnets 173 is Nm, the following conditions are satisfied: Nc = 6; Nm = 9; and Nc + Nm = 15. In this embodiment, Nm is a sum of magnetic poles on one side of the magnets 173 of the three driving units 170 facing the coil assemblies 171.

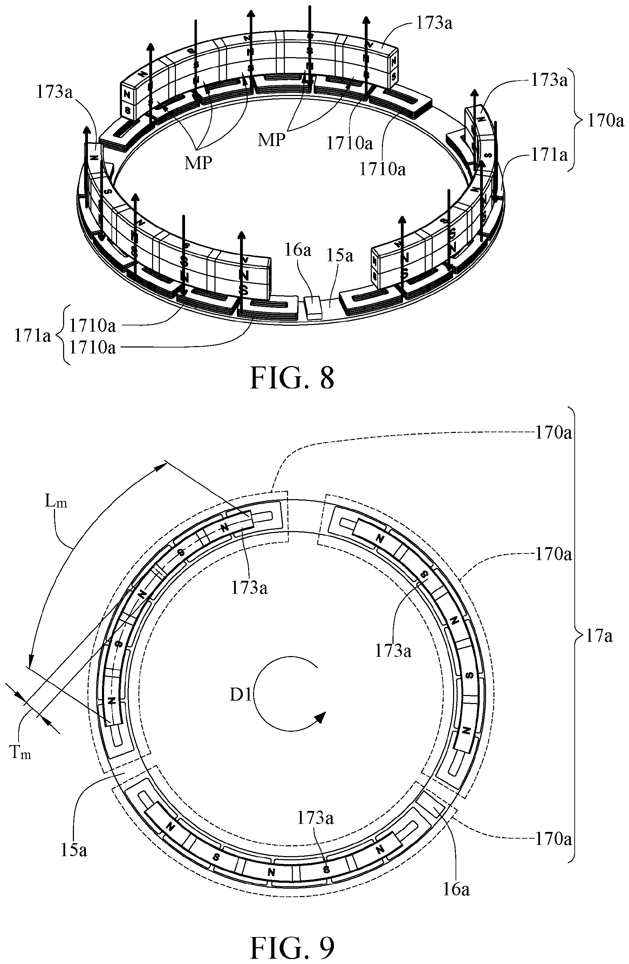

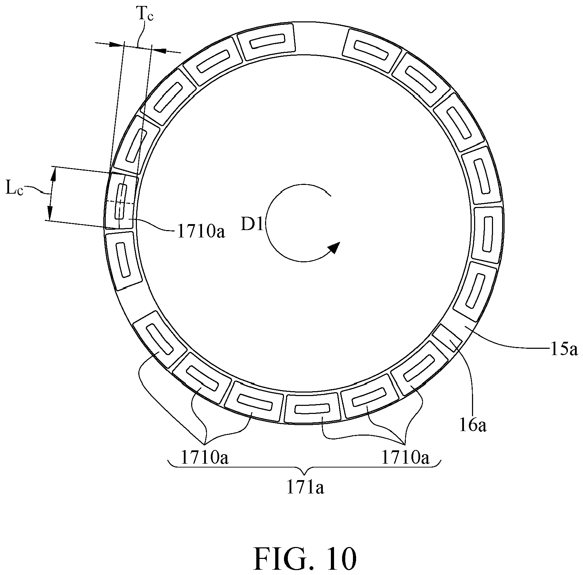

The present disclosure is not limited to the above described configuration of the driving mechanism 17. In other configurations, the number of driving units of the driving mechanism, the number of coils of each coil assembly, and the number of magnetic poles of each magnet can be modified according to various design requirements. For example, please refer to Fig. 8 to Fig. 10. Fig. 8 is a perspective view of a driving mechanism, a Hall sensor and a flexible printed circuit according to another embodiment of the present disclosure, Fig. 9 is a top view of the driving mechanism, the Hall sensor and the flexible printed circuit in Fig. 8, and Fig. 10 is a top view of coil assemblies of the driving mechanism, the Hall sensor and the flexible printed circuit in Fig. 8.

In one configuration of the present disclosure, a driving mechanism 17a of an adjustable aperture module includes three driving units 170a, and each of the driving units 170a includes a coil assembly 171a and a magnet 173a that are disposed corresponding to each other. The coil assemblies 171a are disposed on a flexible printed circuit 15a and arranged along a circumferential direction D1, and the magnets 173a are disposed on a movable component and arranged along the circumferential direction D1. In addition, each of the magnets 173a is a sectorial-shaped integrated magnet.

Each of the coil assemblies 171a includes six coils 1710a that are arranged along the circumferential direction D1, and each of the magnets 173a includes a plurality of magnetic poles MP that are arranged along the circumferential direction D1. In detail, from the perspective of one of the driving units 170a, the magnet 173a includes five magnetic poles MP disposed corresponding to the coil assembly 171a and facing the coil assembly 171a, and each of the five magnetic poles MP faces two of the coils 1710a of the coil assembly 171a. Fig. 8 shows multiple arrows passing through the magnets 173a to represent the direction of the magnetic field lines of the magnets 173a, but the present disclosure is not limited to the configuration of North (N) and South (S) poles, as well as the direction of the magnetic field lines as shown in Fig. 8.

A Hall sensor 16a is disposed on the flexible printed circuit 15a and located on one side of one of the coil assemblies 171a in the circumferential direction D1. In addition, the magnets 173a of the driving units 170a are not aligned to face toward the Hall sensor 16a.

When a length of each of the magnets 173a in the circumferential direction D1 is Lm, and a radial thickness of each of the magnets 173a is Tm, the following conditions are satisfied: Lm = 8.11 mm; Tm = 0.52 mm; and Lm/Tm = 15.6.

When a length of each of the coils 1710a in the circumferential direction D1 is Lc, and a radial thickness of each of the coils 1710a is Tc, the following conditions are satisfied: Lc = 1.55 mm; Tc = 0.8 mm; and Lc/Tc = 1.9.

When a number of the driving units 170a is Nd, the following condition is satisfied: Nd = 3. When a number of coils facing the magnets 173a in the coil assemblies 171a is Nc, and a number of magnetic poles facing the coil assemblies 171a among the magnets 173a is Nm, the following conditions are satisfied: Nc = 18; Nm = 15; and Nc + Nm = 33.

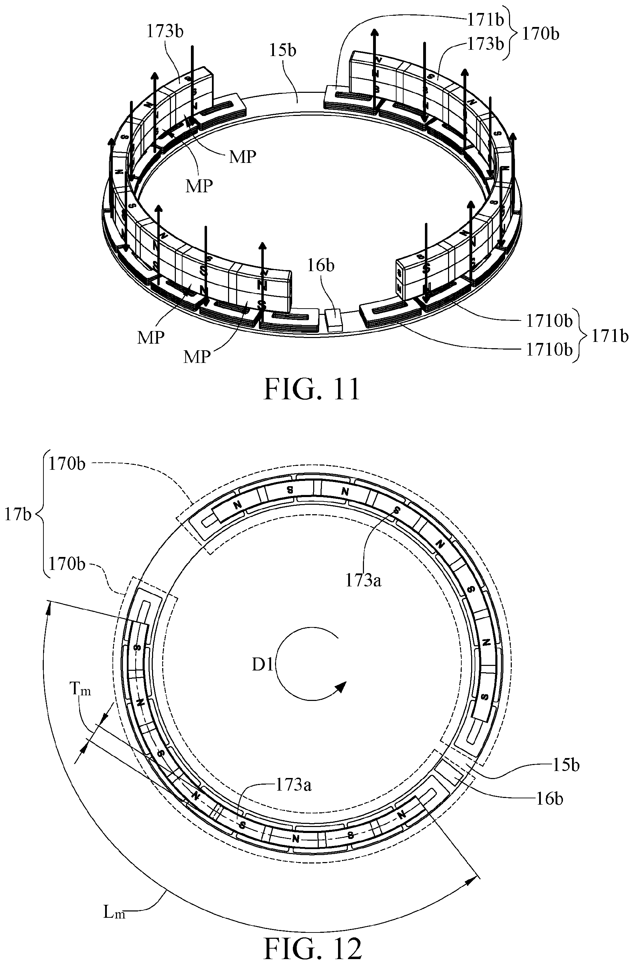

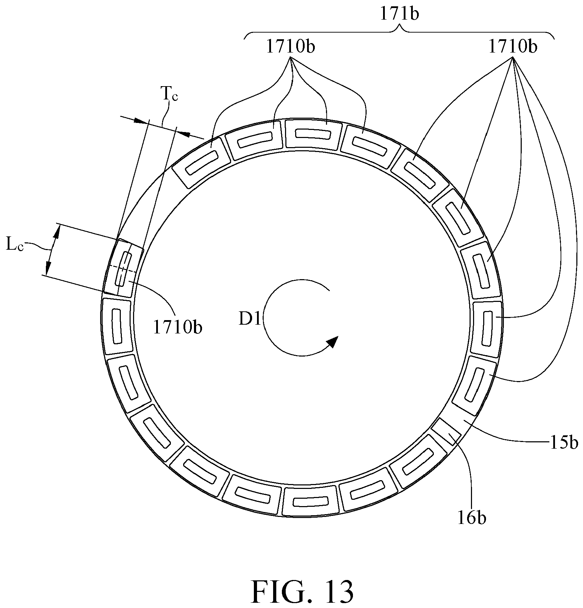

Furthermore, as an additional implementation, please refer to Fig. 11 to Fig. 13. Fig. 11 is a perspective view of a driving mechanism, a Hall sensor and a flexible printed circuit according to another embodiment of the present disclosure, Fig. 12 is a top view of the driving mechanism, the Hall sensor and the flexible printed circuit in Fig. 11, and Fig. 13 is a top view of coil assemblies of the driving mechanism, the Hall sensor and the flexible printed circuit in Fig. 11. In another configuration of the present disclosure, a driving mechanism 17b of an adjustable aperture module includes two driving units 170b, and each of the driving units 170b includes a coil assembly 171b and a magnet 173b that are disposed corresponding to each other. The coil assemblies 171b are disposed on a flexible printed circuit 15b and arranged along a circumferential direction D1, and the magnets 173b are disposed on a movable component and arranged along the circumferential direction D1. In addition, each of the magnets 173b is a sectorial-shaped integrated magnet.

Each of the coil assemblies 171b includes nine coils 1710b that are arranged along the circumferential direction D1, and each of the magnets 173b includes a plurality of magnetic poles MP that are arranged along the circumferential direction D1. In detail, from the perspective of one of the driving units 170b, the magnet 173b includes eight magnetic poles MP disposed corresponding to the coil assembly 171b and facing the coil assembly 171b, and each of the eight magnetic poles MP faces two of the coils 1710b of the coil assembly 171b. Fig. 11 shows multiple arrows passing through the magnets 173b to represent the direction of the magnetic field lines of the magnets 173b, but the present disclosure is not limited to the configuration of North (N) and South (S) poles, as well as the direction of the magnetic field lines as shown in Fig. 11.

A Hall sensor 16b is disposed on the flexible printed circuit 15b and located on one side of one of the coil assemblies 171b in the circumferential direction D1. In addition, the magnets 173b of the driving units 170b are not aligned to face toward the Hall sensor 16b.

When a length of each of the magnets 173b in the circumferential direction D1 is Lm, and a radial thickness of each of the magnets 173b is Tm, the following conditions are satisfied: Lm = 13.11 mm; Tm = 0.52 mm; and Lm/Tm = 25.2.

When a length of each of the coils 1710b in the circumferential direction D1 is Lc, and a radial thickness of each of the coils 1710b is Tc, the following conditions are satisfied: Lc = 1.55 mm; Tc = 0.8 mm; and Lc/Tc = 1.9.

When a number of the driving units 170b is Nd, the following condition is satisfied: Nd = 2. When a number of coils facing the magnets 173b in the coil assemblies 171b is Nc, and a number of magnetic poles facing the coil assemblies 171b among the magnets 173b is Nm, the following conditions are satisfied: Nc = 18; Nm = 16; and Nc + Nm = 34.

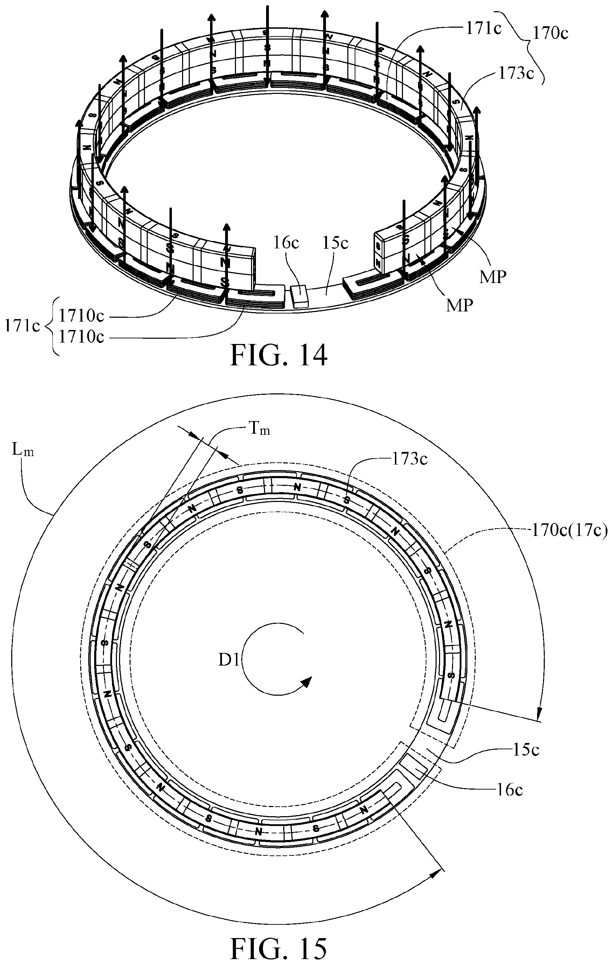

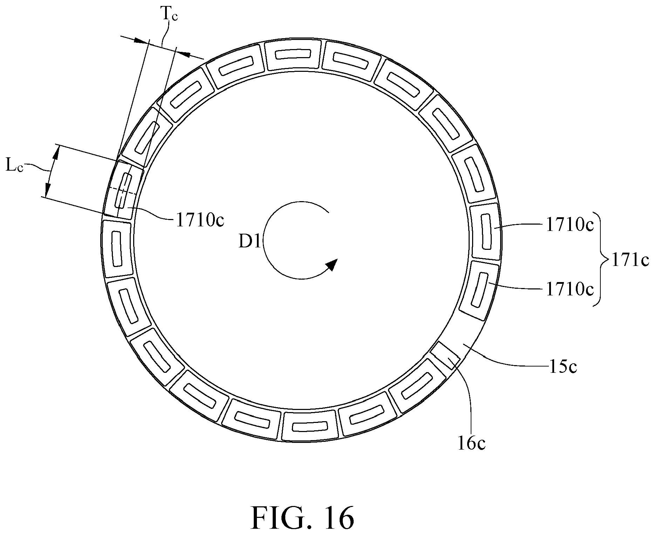

Furthermore, as an additional implementation, please refer to Fig. 14 to Fig. 16. Fig. 14 is a perspective view of a driving mechanism, a Hall sensor and a flexible printed circuit according to another embodiment of the present disclosure, Fig. 15 is a top view of the driving mechanism, the Hall sensor and the flexible printed circuit in Fig. 14, and Fig. 16 is a top view of a coil assembly of the driving mechanism, the Hall sensor and the flexible printed circuit in Fig. 14. In another configuration of the present disclosure, a driving mechanism 17c of an adjustable aperture module includes a driving unit 170c, and the driving unit 170c includes a coil assembly 171c and a magnet 173c that are disposed corresponding to each other. The coil assembly 171c is disposed on a flexible printed circuit 15c and arranged along a circumferential direction D1, and the magnet 173c is disposed on a movable component and arranged along the circumferential direction D1. In addition, the magnet 173c is a sectorial-shaped integrated magnet 173c.

The coil assembly 171c includes nineteen coils 1710c that are arranged along the circumferential direction D1, and the magnet 173c includes a plurality of magnetic poles MP that are arranged along the circumferential direction D1. In detail, the magnet 173c includes eighteen magnetic poles MP disposed corresponding to the coil assembly 171c and facing the coil assembly 171c, and each of the eighteen magnetic poles MP faces two of the coils 1710c of the coil assembly 171c. Fig. 14 shows multiple arrows passing through the magnet 173c to represent the direction of the magnetic field lines of the magnet 173c, but the present disclosure is not limited to the configuration of North (N) and South (S) poles, as well as the direction of the magnetic field lines as shown in Fig. 14.

A Hall sensor 16c is disposed on the flexible printed circuit 15c and located on one side of the coil assembly 171c in the circumferential direction D1. In addition, the magnet 173c of the driving unit 170c is not aligned to face toward the Hall sensor 16c.

When a length of the magnet 173c in the circumferential direction D1 is Lm, and a radial thickness of the magnet 173c is Tm, the following conditions are satisfied: Lm = 29.8 mm; Tm = 0.52 mm; and Lm/Tm = 57.3.

When a length of each of the coils 1710c in the circumferential direction D1 is Lc, and a radial thickness of each of the coils 1710c is Tc, the following conditions are satisfied: Lc = 1.55 mm; Tc = 0.8 mm; and Lc/Tc = 1.9.

When a number of the driving unit 170c is Nd, the following condition is satisfied: Nd = 1. When a number of coils facing the magnet 173c in the coil assembly 171c is Nc, and a number of magnetic poles facing the coil assembly 171c of the magnet 173c is Nm, the following conditions are satisfied: Nc = 19; Nm = 18; and Nc + Nm = 37.

**2nd Embodiment**

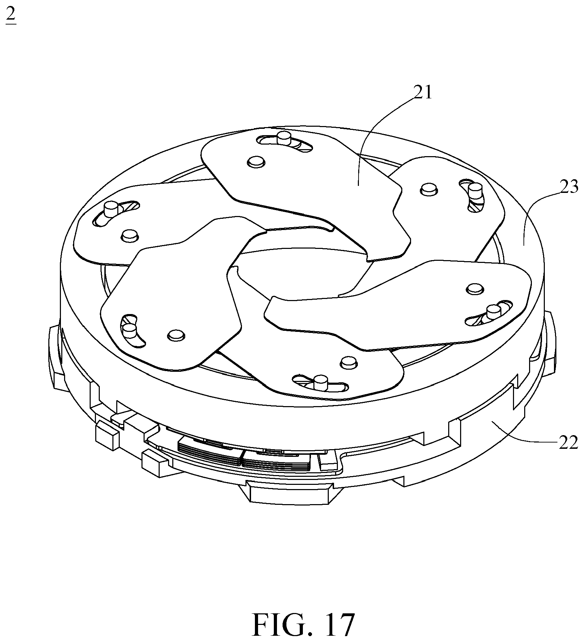

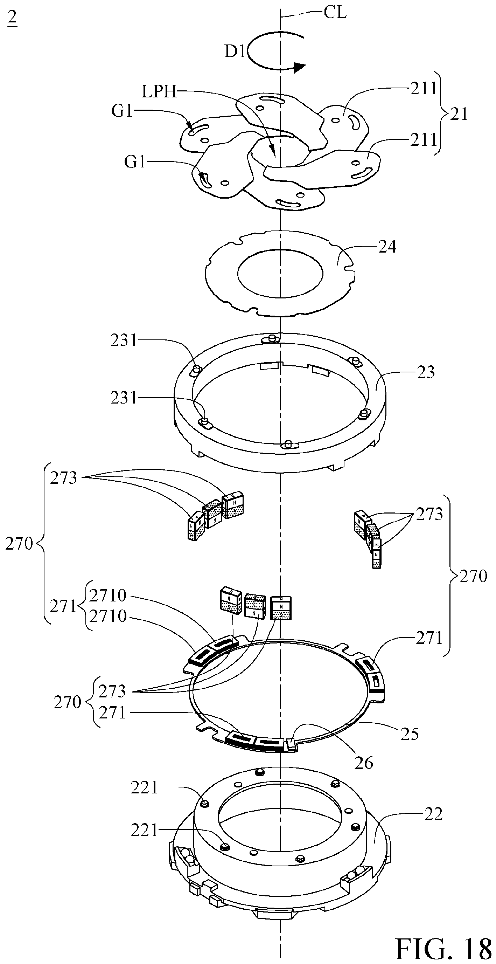

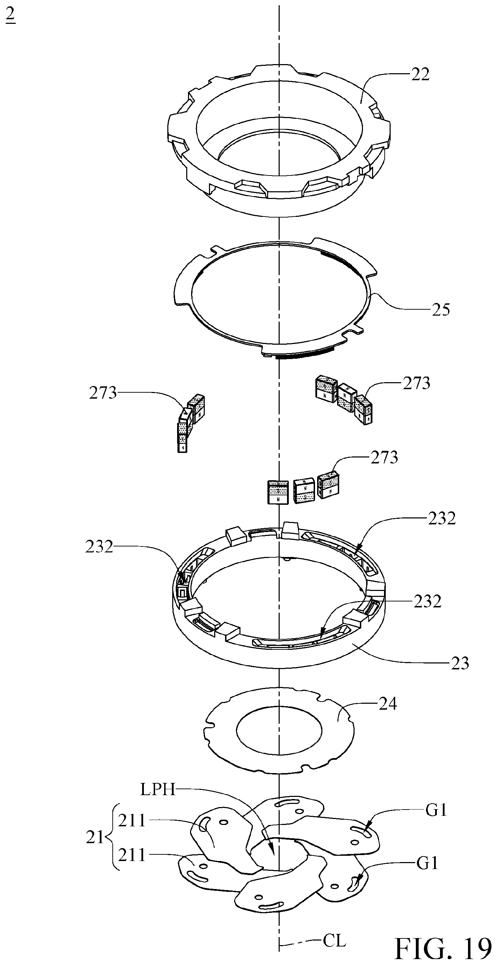

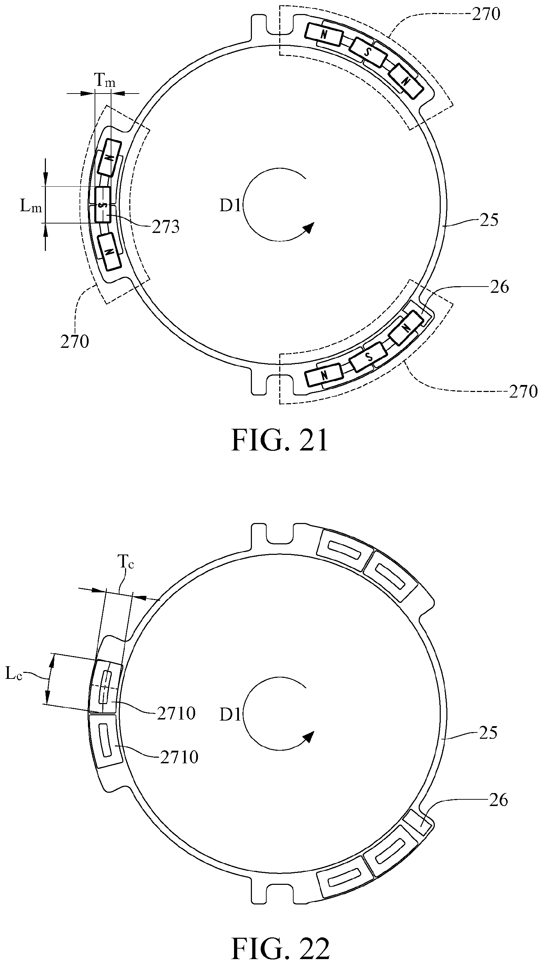

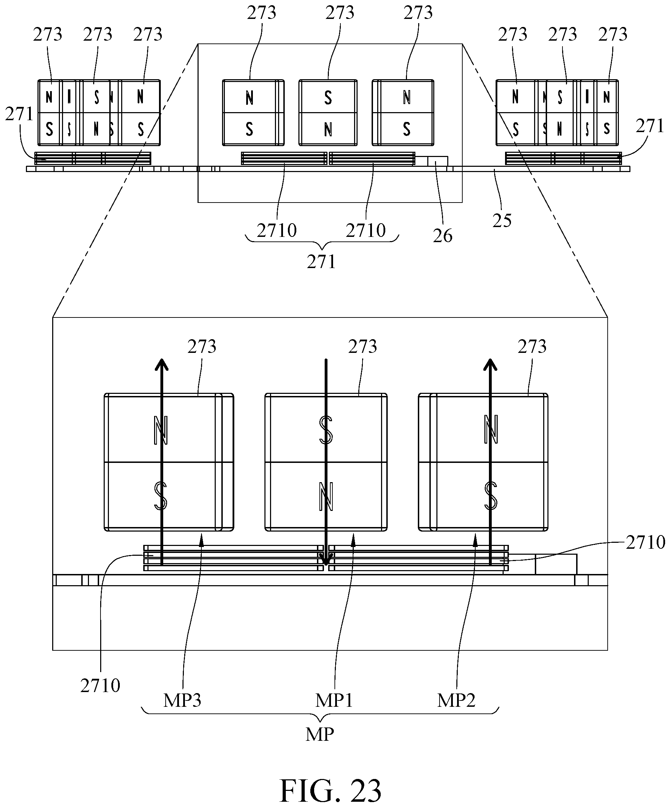

Fig. 17 is a perspective view of an adjustable aperture module according to the 2nd embodiment of the present disclosure, Fig. 18 is an exploded view of the adjustable aperture module in Fig. 17, Fig. 19 is another exploded view of the adjustable aperture module in Fig. 17, Fig. 20 shows a perspective view of a driving mechanism, a Hall sensor and a flexible printed circuit of the adjustable aperture module in Fig. 17, as well as a partially enlarged view of the perspective view, Fig. 21 is a top view of the driving mechanism, the Hall sensor and the flexible printed circuit of the adjustable aperture module in Fig. 17, Fig. 22 is a top view of the flexible printed circuit, the Hall sensor and coil assemblies of a driving mechanism of the adjustable aperture module in Fig. 17, and Fig. 23 shows a side view of the driving mechanism, the Hall sensor and the flexible printed circuit of the adjustable aperture module in Fig. 17, as well as a partially enlarged view of the side view.

In this embodiment, an adjustable aperture module 2 includes a blade assembly 21, a fixed component 22, a movable component 23, a fixed aperture component 24, a flexible printed circuit 25, a Hall sensor 26 and a driving mechanism 27.

The blade assembly 21 includes six light-blocking blades 211 overlapping one another in a circumferential direction D1 surrounding a central axis CL of the adjustable aperture module 2 and together form a light pass aperture LPH. In addition, an aperture size of the light pass aperture LPH is adjustable.

The fixed component 22 is connected to the blade assembly 21. In specific, the light-blocking blades 211 of the blade assembly 21 are rotatably disposed on six shaft structures 221 of the fixed component 22, respectively, such that each of the light-blocking blades 211 of the blade assembly 21 is pivotable relative to the fixed component 22.

The movable component 23 is connected to the blade assembly 21 and disposed corresponding to the fixed component 22. In specific, six connection protrusions 231 of the movable component 23 are slidably disposed in grooves G1 of the light-blocking blades 211, respectively, such that when the driving mechanism 27 rotates the movable component 23 in the circumferential direction D1 relative to the fixed component 22, the movable component 23 drives the light-blocking blades 211 of the blade assembly 21 to pivot relative to the fixed component 22 so as to adjust the aperture size of the light pass aperture LPH.

The fixed aperture component 24 is disposed on the fixed component 22, and the fixed aperture component 24 is disposed corresponding to the light-blocking blades 211 so as to define a fixed F-number. Furthermore, the fixed aperture component 24 is located close to the blade assembly 21 and coaxially arranged with the blade assembly 21.

The flexible printed circuit 25 is attached to the fixed component 22, and the Hall sensor 26 is disposed on the flexible printed circuit 25.

The driving mechanism 27 includes three driving units 270, and each of the driving units 270 includes a coil assembly 271 and three magnets 273 that are disposed corresponding to each other. The coil assemblies 271 are disposed on the flexible printed circuit 25 and arranged along the circumferential direction D1, and the magnets 273 are disposed on the movable component 23 and arranged along the circumferential direction D1. In addition, the movable component 23 includes three mounting structures 232, and the magnets 273 of the driving units 270 are disposed in the mounting structures 232, respectively. In this embodiment, each of the magnets 273 is a rectangular magnet, and the mounting structures 232 have a plurality of recesses (not numbered) configured for to receive the magnets 273.

Each of the coil assemblies 271 includes two coils 2710 that are arranged along the circumferential direction D1, and each of the magnets 273 includes a plurality of magnetic poles MP that are arranged along the circumferential direction D1. In detail, from the perspective of one of the driving units 270, the magnets 273 include three magnetic poles MP disposed corresponding to the coil assembly 271 and facing the coil assembly 271. The three magnetic poles MP include a first magnetic pole MP1, a second magnetic pole MP2 and a third magnetic pole MP3. The first magnetic pole MP1, the second magnetic pole MP2 and the third magnetic pole MP3 are located at the three magnets 273, respectively. The first magnetic pole MP1 faces the two coils 2710 of the coil assembly 271, the second magnetic pole MP2 faces one of the coils 2710 of the coil assembly 271, and the third magnetic pole MP3 faces one of the coils 2710 of the coil assembly 271. In addition, the Hall sensor 26 is located adjacent to one of the coil assemblies 271 and located on one side of the coil assembly 271 in the circumferential direction D1, and the Hall sensor 26 faces the second magnetic pole MP2. Furthermore, as shown in Fig. 20, the second magnetic pole MP2 faces the Hall sensor 26 and one of the coils 2710 of the coil assembly 271 located closest to the Hall sensor 26. Fig. 23 shows multiple arrows passing through the magnets 273 to represent the direction of the magnetic field lines of each of the magnets 273. However, it should be noted that the configuration of N and S poles, as well as the direction of the magnetic field lines, is not limited to that as shown in Fig. 23. In some other configurations, the magnets can be configured with two N poles and one S pole facing the coil assembly, and the S pole is located between the N poles. Additionally, the arrows representing the direction of the magnetic field lines of the magnets can have the arrows on the sides pointing towards the coil assembly, and the arrow in the middle points away from the coil assembly. When a length of each of the magnets 273 in the circumferential direction D1 is Lm, and a radial thickness of each of the magnets 273 is Tm, the following conditions are satisfied: Lm = 1.1 mm; Tm = 0.48 mm; and Lm/Tm = 2.3.

When a length of each of the coils 2710 in the circumferential direction D1 is Lc, and a radial thickness of each of the coils 2710 is Tc, the following conditions are satisfied: Lc = 1.55 mm; Tc = 0.8 mm; and Lc/Tc = 1.9.

When a number of the driving units 270 is Nd, the following condition is satisfied: Nd = 3.

When a number of coils facing the magnets 273 in the coil assemblies 271 is Nc, and a number of magnetic poles facing the coil assemblies 271 among the magnets 273 is Nm, the following conditions are satisfied: Nc = 6; Nm = 9; and Nc + Nm = 15. In this embodiment, Nm is a sum of magnetic poles on one side of the magnets 273 of the three driving units 270 facing the coil assemblies 271.

When the number of coils facing the magnets 273 in the coil assemblies 271 is Nc, the number of magnetic poles facing the coil assemblies 271 among the magnets 273 is Nm, and a number of the Hall sensor 26 is Nh, the following conditions are satisfied: Nc = 6; Nm = 9; Nh = 1; and Nc + Nm + Nh = 16.

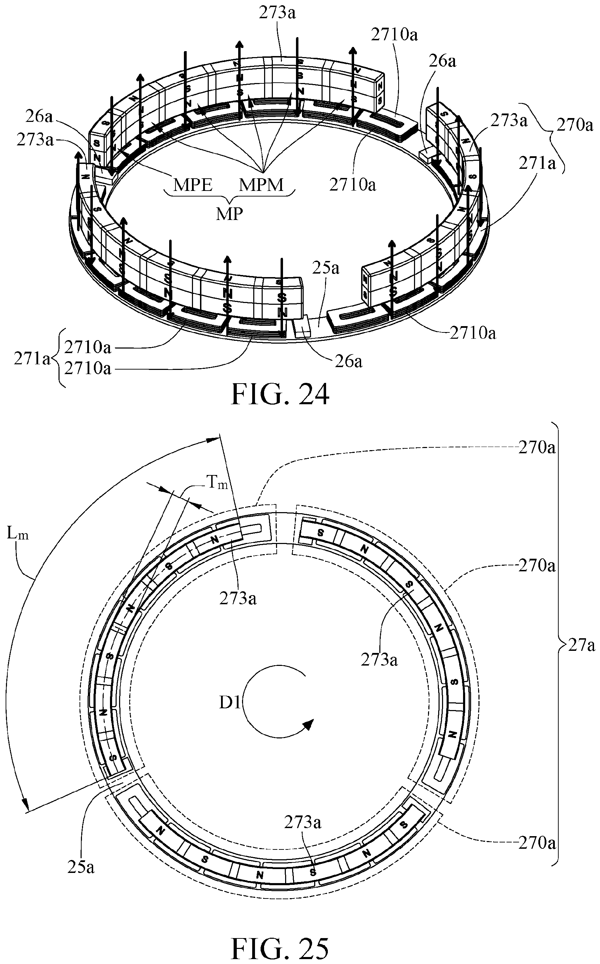

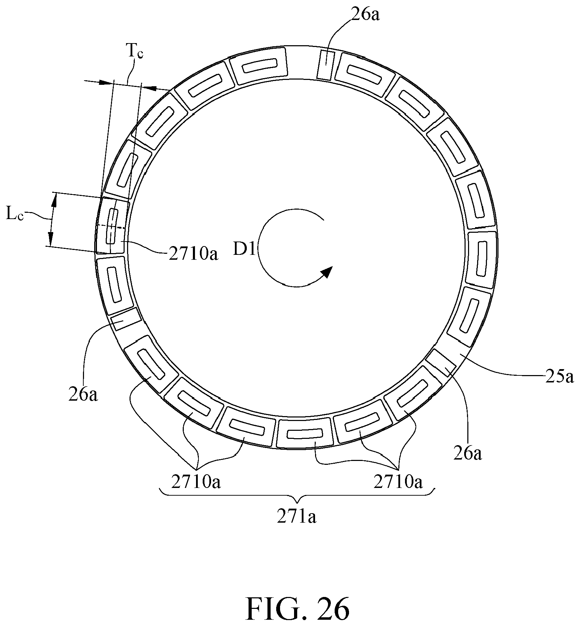

The present disclosure is not limited to the above described configuration of the driving mechanism 27. In other configurations, the number of Hall sensor, the number of driving units of the driving mechanism, the number of coils of each coil assembly, the shape of the magnets and the number of magnetic poles of each magnet can be modified according to various design requirements. For example, please refer to Fig. 24 to Fig. 26. Fig. 24 is a perspective view of a driving mechanism, Hall sensors and a flexible printed circuit according to another embodiment of the present disclosure, Fig. 25 is a top view of the driving mechanism, the Hall sensors and the flexible printed circuit in Fig. 24, and Fig. 26 is a top view of coil assemblies of the driving mechanism, the Hall sensors and the flexible printed circuit in Fig. 24.

In one configuration of the present disclosure, an adjustable aperture module includes three Hall sensors 26a, and the Hall sensors 26a are arranged along a circumferential direction D1. A driving mechanism 27a of the adjustable aperture module includes three driving units 270a, and each of the driving units 270a includes a coil assembly 271a and a magnet 273a that are disposed corresponding to each other. The coil assemblies 271a are disposed on a flexible printed circuit 25a and arranged along the circumferential direction D1, and the magnets 273a are disposed on a movable component and arranged along the circumferential direction D1. In addition, each of the magnets 273a is a sectorial-shaped integrated magnet.

Each of the coil assemblies 271a includes six coils 2710a that are arranged along the circumferential direction D1, each of the magnets 273a includes a plurality of magnetic poles MP that are arranged along the circumferential direction D1, and each of the Hall sensors 26a is located adjacent to one of the coil assemblies 271a and located on one side of the coil assembly 271a in the circumferential direction D1. In detail, from the perspective of one of the driving units 270a and one of the Hall sensors 26a located closest to the driving unit 270a, the magnet 273a includes six magnetic poles MP disposed corresponding to the coil assembly 271a and facing the coil assembly 271a. In addition, each of five magnetic poles MPM of the six magnetic poles MP faces two of the coils 2710a of the coil assembly 271a, and the other magnetic pole MPE of the six magnetic poles MP (i.e., the magnetic pole MPE located at one end of the magnet 273a) faces the Hall sensor 26a and one of the coils 2710a of the coil assembly 271a located closest to the Hall sensor 26a. Fig. 24 shows multiple arrows passing through the magnets 273a to represent the direction of the magnetic field lines of the magnets 273a, but the present disclosure is not limited to the configuration of North (N) and South (S) poles, as well as the direction of the magnetic field lines as shown in Fig. 24.

When a length of each of the magnets 273a in the circumferential direction D1 is Lm, and a radial thickness of each of the magnets 273a is Tm, the following conditions are satisfied: Lm = 9.41 mm; Tm = 0.52 mm; and Lm/Tm = 18.1.

When a length of each of the coils 2710a in the circumferential direction D1 is Lc, and a radial thickness of each of the coils 2710a is Tc, the following conditions are satisfied: Lc = 1.55 mm; Tc = 0.8 mm; and Lc/Tc = 1.9.

When a number of the driving units 270a is Nd, the following condition is satisfied: Nd = 3. When a number of coils facing the magnets 273a in the coil assemblies 271a is Nc, and a number of magnetic poles facing the coil assemblies 271a among the magnets 273a is Nm, the following conditions are satisfied: Nc = 18; Nm = 18; and Nc + Nm = 36.

When the number of coils facing the magnets 273a in the coil assemblies 271a is Nc, the number of magnetic poles facing the coil assemblies 271a among the magnets 273a is Nm, and a number of the Hall sensors 26a is Nh, the following conditions are satisfied: Nc = 18; Nm = 18; Nh = 3; and Nc + Nm + Nh = 39.

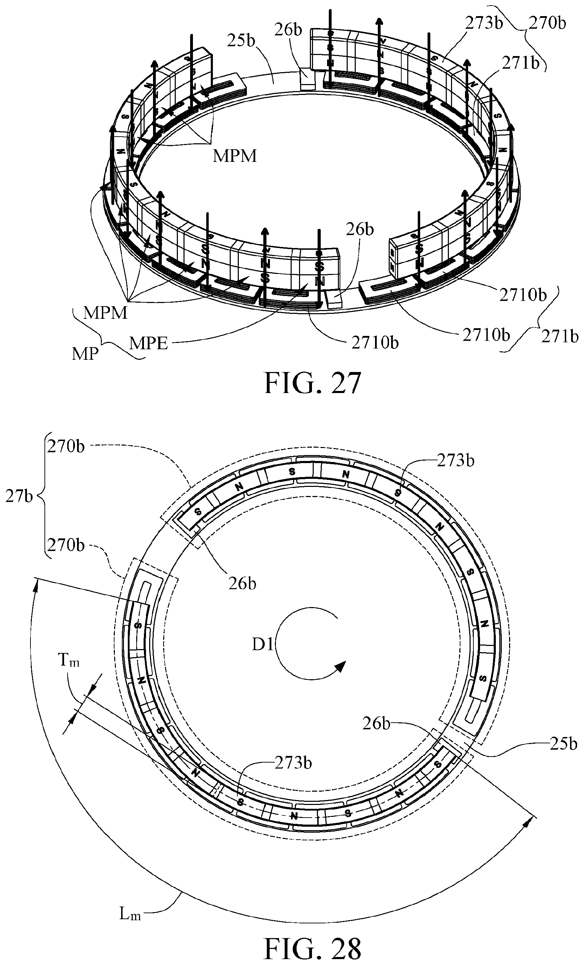

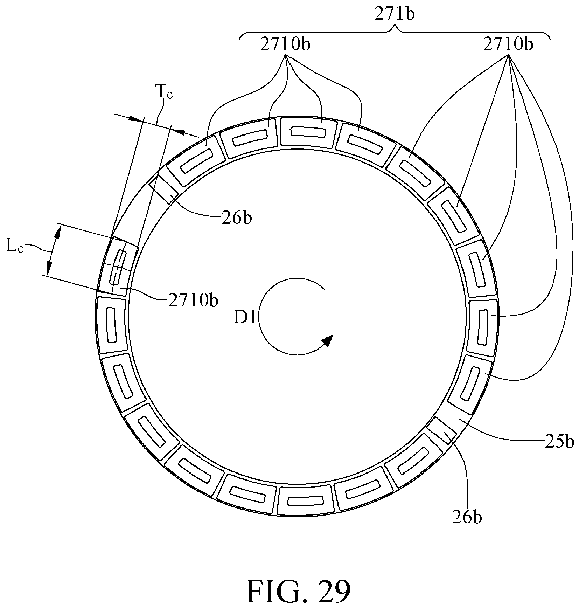

Furthermore, as an additional implementation, please refer to Fig. 27 to Fig. 29, Fig. 27 is a perspective view of a driving mechanism, Hall sensors and a flexible printed circuit according to another embodiment of the present disclosure, Fig. 28 is a top view of the driving mechanism, the Hall sensors and the flexible printed circuit in Fig. 27, and Fig. 29 is a top view of coil assemblies of the driving mechanism, the Hall sensors and the flexible printed circuit in Fig. 27. In another configuration of the present disclosure, an adjustable aperture module includes two Hall sensors 26b, and the Hall sensors 26b are arranged along a circumferential direction D1. A driving mechanism 27b of the adjustable aperture module includes two driving units 270b, and each of the driving units 270b includes a coil assembly 271b and a magnet 273b that are disposed corresponding to each other. The coil assemblies 271b are disposed on a flexible printed circuit 25b and arranged along the circumferential direction D1, and the magnets 273b are disposed on a movable component and arranged along the circumferential direction D1. In addition, each of the magnets 273b is a sectorial-shaped integrated magnet.

Each of the coil assemblies 271b includes nine coils 2710b that are arranged along the circumferential direction D1, each of the magnets 273b includes a plurality of magnetic poles MP that are arranged along the circumferential direction D1, and each of the Hall sensors 26b is located adjacent to one of the coil assemblies 271b and located on one side of the coil assembly 271b in the circumferential direction D1. In detail, from the perspective of one of the driving units 270b and one of the Hall sensors 26b located closest to the driving unit 270b, the magnets 273b include nine magnetic poles MP disposed corresponding to the coil assembly 271b and facing the coil assembly 271b. In addition, each of eight magnetic poles MPM of the nine magnetic poles MP faces two of the coils 2710b of the coil assembly 271b, and the other magnetic pole MPE of the nine magnetic poles MP (i.e., the magnetic pole MPE located at one end of the magnet 273b) faces the Hall sensor 26b and one of the coils 2710b of the coil assembly 271b located closest to the Hall sensor 26b. Fig. 27 shows multiple arrows passing through the magnets 273b to represent the direction of the magnetic field lines of the magnets 273b, but the present disclosure is not limited to the configuration of North (N) and South (S) poles, as well as the direction of the magnetic field lines as shown in Fig. 27.

When a length of each of the magnets 273b in the circumferential direction D1 is Lm, and a radial thickness of each of the magnets 273b is Tm, the following conditions are satisfied: Lm = 14.41 mm; Tm = 0.52 mm; and Lm/Tm = 27.7.

When a length of each of the coils 2710b in the circumferential direction D1 is Lc, and a radial thickness of each of the coils 2710b is Tc, the following conditions are satisfied: Lc = 1.55 mm; Tc = 0.8 mm; and Lc/Tc = 1.9.

When a number of the driving units 270b is Nd, the following condition is satisfied: Nd = 2. When a number of coils facing the magnets 273b in the coil assemblies 271b is Nc, and a number of magnetic poles facing the coil assemblies 271b among the magnets 273b is Nm, the following conditions are satisfied: Nc = 18; Nm = 18; and Nc + Nm = 36.

When the number of coils facing the magnets 273b in the coil assemblies 271b is Nc, the number of magnetic poles facing the coil assemblies 271b among the magnets 273b is Nm, and a number of the Hall sensors 26b is Nh, the following conditions are satisfied: Nc = 18; Nm = 18; Nh = 2; and Nc + Nm + Nh = 38.

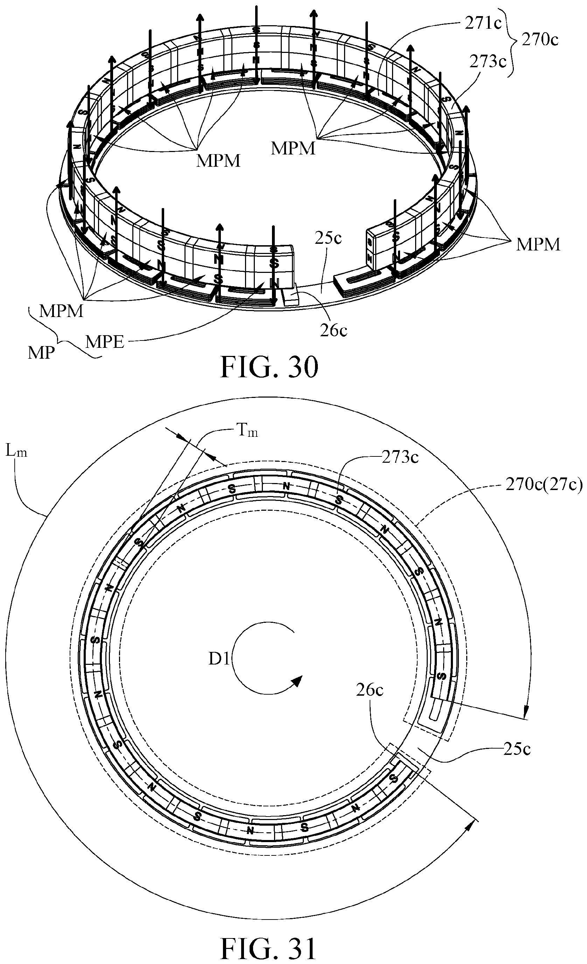

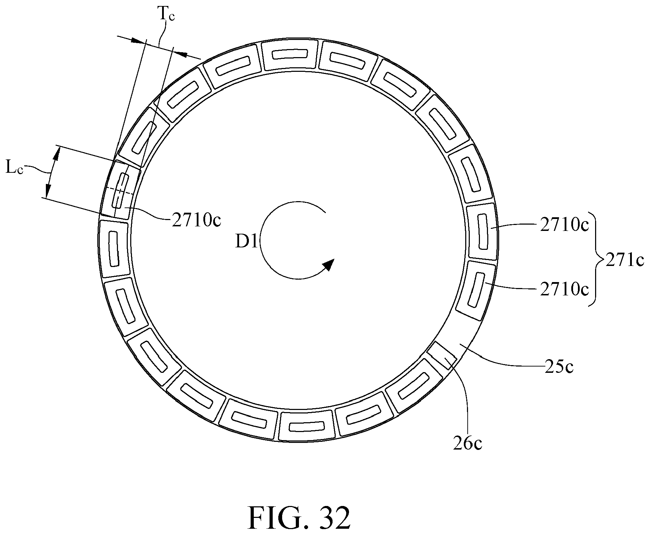

Furthermore, as an additional implementation, please refer to Fig. 30 to Fig. 32. Fig. 30 is a perspective view of a driving mechanism, a Hall sensor and a flexible printed circuit according to another embodiment of the present disclosure, Fig. 31 is a top view of the driving mechanism, the Hall sensor and the flexible printed circuit in Fig. 30, and Fig. 32 is a top view of a coil assembly of the driving mechanism, the Hall sensor and the flexible printed circuit in Fig. 30. In another configuration of the present disclosure, an adjustable aperture module includes a Hall sensor 26c, a driving mechanism 27c of the adjustable aperture module includes a driving unit 270c, and the driving unit 270c includes a coil assembly 271c and a magnet 273c that are disposed corresponding to each other. The coil assembly 271c is disposed on the flexible printed circuit 25c and arranged along the circumferential direction D1, and the magnet 273c is disposed on a movable component and arranged along the circumferential direction D1. In addition, the magnet 273c is a sectorial-shaped integrated magnet.

The coil assembly 271c includes nineteen coils 2710c that are arranged along the circumferential direction D1, the magnet 273c includes a plurality of magnetic poles MP that are arranged along the circumferential direction D1, and the Hall sensor 26c is located adjacent to the coil assembly 271c and located on one side of the coil assembly 271c in the circumferential direction D1. In detail, the magnet 273c includes nineteen magnetic poles MP disposed corresponding to the coil assembly 271c and facing the coil assembly 271c. In addition, each of eighteen magnetic poles MPM of the nineteen magnetic poles MP faces two of the coils 2710c of the coil assembly 271c, and the other magnetic pole MPE of the nineteen magnetic poles MP (e., the magnetic pole MPE located at one end of the magnet 273c) faces the Hall sensor 26c and one of the coils 2710c of the coil assembly 271c located closest to the Hall sensor 26c. Fig. 30 shows multiple arrows passing through the magnet 273c to represent the direction of the magnetic field lines of the magnet 273c, but the present disclosure is not limited to the configuration of North (N) and South (S) poles, as well as the direction of the magnetic field lines as shown in Fig. 30.

When a length of the magnet 273c in the circumferential direction D1 is Lm, and a radial thickness of the magnet 273c is Tm, the following conditions are satisfied: Lm = 31.09 mm; Tm = 0.52 mm; and Lm/Tm = 59.8.

When a length of each of the coils 2710c in the circumferential direction D1 is Lc, and a radial thickness of each of the coils 2710c is Tc, the following conditions are satisfied: Lc = 1.55 mm; Tc = 0.8 mm; and Lc/Tc = 1.9.

When a number of the driving unit 270c is Nd, the following condition is satisfied: Nd = 1. When a number of coils facing the magnet 273c in the coil assembly 271c is Nc, and a number of magnetic poles facing the coil assembly 271c in the magnet 273c is Nm, the following conditions are satisfied: Nc = 19; Nm = 19; and Nc + Nm = 38.

When the number of coils facing the magnet 273c in the coil assembly 271c is Nc, the number of magnetic poles facing the coil assembly 271c in the magnet 273c is Nm, and a number of the Hall sensor 26c is Nh, the following conditions are satisfied: Nc = 19; Nm = 19; Nh = 1; and Nc + Nm + Nh = 39.

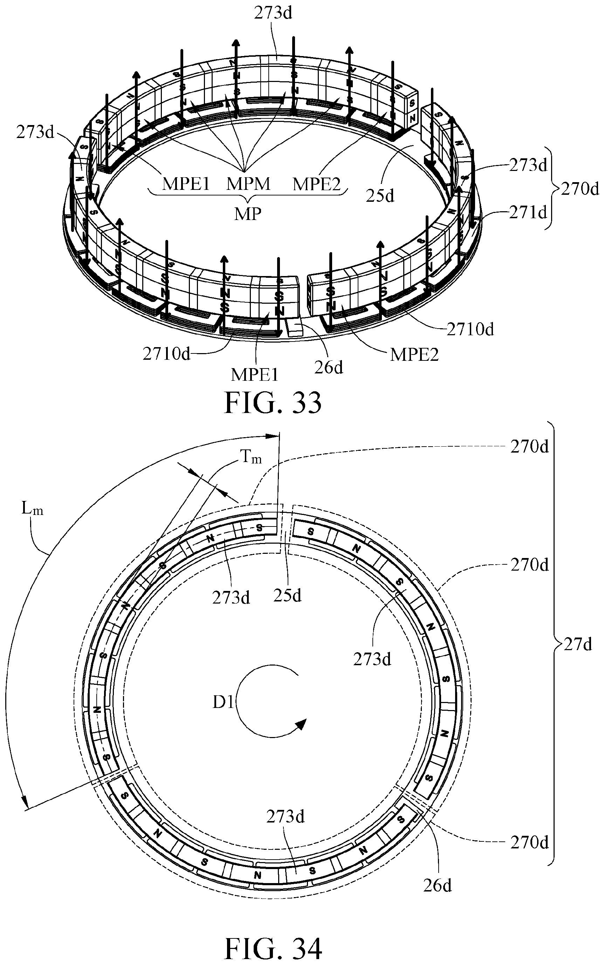

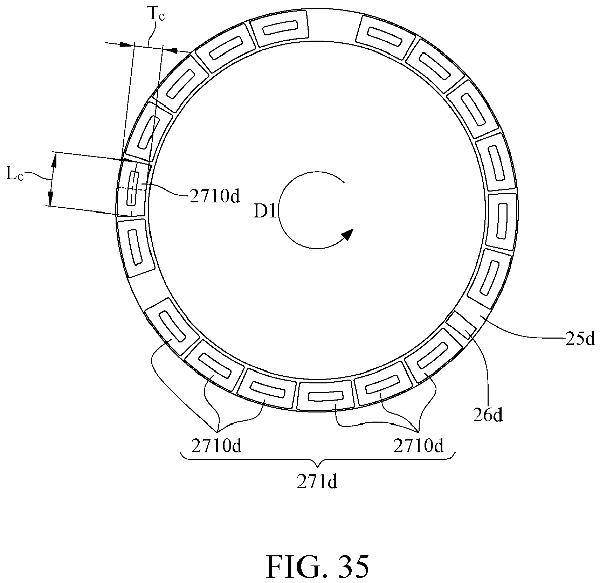

Furthermore, as an additional implementation, please refer to Fig. 33 to Fig. 35. Fig. 33 is a perspective view of a driving mechanism, a Hall sensor and a flexible printed circuit according to another embodiment of the present disclosure, Fig. 34 is a top view of the driving mechanism, the Hall sensor and the flexible printed circuit in Fig. 33, and Fig. 35 is a top view of coil assemblies of the driving mechanism, the Hall sensor and the flexible printed circuit in Fig. 33. In another configuration of the present disclosure, an adjustable aperture module includes a Hall sensor 26d arranged along the circumferential direction D1. A driving mechanism 27d of the adjustable aperture module includes three driving units 270d, and each of the driving units 270d includes a coil assembly 271d and a magnets 273d that are disposed corresponding to each other. The coil assemblies 271d are disposed on a flexible printed circuit 25d and arranged along the circumferential direction D1, and the magnets 273d are disposed on a movable component and arranged along the circumferential direction D1. In addition, each of the magnets 273d is sectorial-shaped integrated magnet.

Each of the coil assemblies 271d includes six coils 2710d that are arranged along the circumferential direction D1, and each of the magnets 273d includes a plurality of magnetic poles MP that are arranged along the circumferential direction D1. In detail, from the perspective of one of the driving units 270d, the magnet 273d includes seven magnetic poles MP disposed corresponding to the coil assembly 271d and facing the coil assembly 271d. In addition, each of five magnetic poles MPM of the seven magnetic poles MP faces two of the coils 2710d of the coil assembly 271d, and the other two magnetic poles MPE1 and MPE2 of the seven magnetic poles MP located at two ends of the magnet 273d, respectively, each faces one of the coils 2710d of the coil assembly 271d. Fig. 33 shows multiple arrows passing through the magnets 273d to represent the direction of the magnetic field lines of the magnets 273d, but the present disclosure is not limited to the configuration of North (N) and South (S) poles, as well as the direction of the magnetic field lines as shown in Fig. 33.

The Hall sensor 26d is located adjacent to one of the coil assemblies 271d and located on one side of the coil assembly 271d in the circumferential direction D1. In addition, in one of the driving units 270d that is located closest to the Hall sensor 26d, the magnetic pole MPE1 located at one end of the magnet 273d faces the Hall sensor 26d and one of the coils 2710d of the coil assemblies 271d located closest to the Hall sensor 26d.

When a length of each of the magnets 273d in the circumferential direction D1 is Lm, and a radial thickness of each of the magnets 273d is Tm, the following conditions are satisfied: Lm = 10.7 mm; Tm = 0.52 mm; and Lm/Tm = 20.6.

When a length of each of the coils 2710d in the circumferential direction D1 is Lc, and a radial thickness of each of the coils 2710d is Tc, the following conditions are satisfied: Lc = 1.55 mm; Tc = 0.8 mm; and Lc/Tc = 1.9.

When a number of the driving units 270d is Nd, the following condition is satisfied: Nd = 3. When a number of coils facing the magnets 273d in the coil assemblies 271d is Nc, and a number of magnetic poles facing the coil assemblies 271d among the magnets 273d is Nm, the following conditions are satisfied: Nc = 18; Nm = 21; and Nc + Nm = 39.

When the number of coils facing the magnets 273d in the coil assemblies 271d is Nc, the number of magnetic poles facing the coil assemblies 271d among the magnets 273d is Nm, and a number of the Hall sensor 26d is Nh, the following conditions are satisfied: Nc = 18; Nm = 21; Nh = 1; and Nc + Nm + Nh = 40.

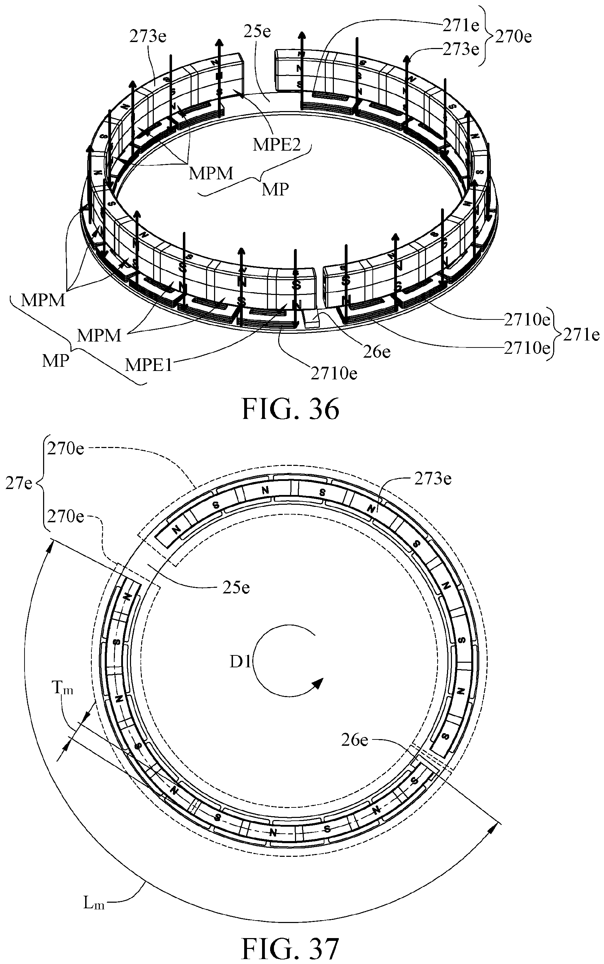

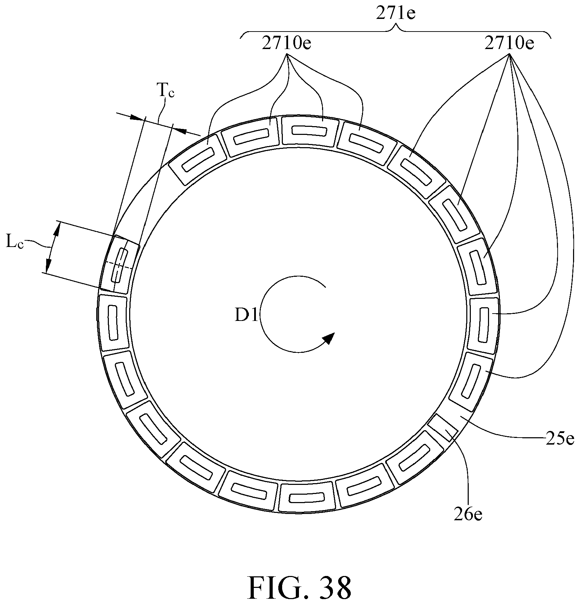

Furthermore, as an additional implementation, please refer to Fig. 36 to Fig. 38. Fig. 36 is a perspective view of a driving mechanism, a Hall sensor and a flexible printed circuit according to another embodiment of the present disclosure, Fig. 37 is a top view of the driving mechanism, the Hall sensor and the flexible printed circuit in Fig. 36, and Fig. 38 is a top view of coil assemblies of the driving mechanism, the Hall sensor and the flexible printed circuit in Fig. 36. In another configuration of the present disclosure, an adjustable aperture module includes a Hall sensor 26e arranged along the circumferential direction D1. A driving mechanism 27e of the adjustable aperture module includes two driving units 270e, and each of the driving units 270e includes a coil assembly 271e and a magnet 273e that are disposed corresponding to each other. The coil assemblies 271e are disposed on a flexible printed circuit 25e and arranged along the circumferential direction D1, and the magnets 273e are disposed on a movable component and arranged along the circumferential direction D1. In addition, each of the magnets 273e is sectorial-shaped integrated magnet.

Each of the coil assemblies 271e includes nine coils 2710e that are arranged along the circumferential direction D1, and each of the magnets 273e includes a plurality of magnetic poles MP that are arranged along the circumferential direction D1. In detail, from the perspective of one of the driving units 270e, the magnet 273e includes ten magnetic poles MP disposed corresponding to the coil assembly 271e and facing the coil assembly 271e. In addition, each of eight magnetic poles MPM of the ten magnetic poles MP faces two of the coils 2710e of the coil assembly 271e, and the other two magnetic poles MPE1 and MPE2 of the ten magnetic poles MP located at two ends of the magnet 273e, respectively, each faces one of the coils 2710e of the coil assembly 271e. Fig. 36 shows multiple arrows passing through the magnet 273e to represent the direction of the magnetic field lines of the magnet 273e, but the present disclosure is not limited to the configuration of North (N) and South (S) poles, as well as the direction of the magnetic field lines as shown in Fig. 36.

The Hall sensor 26e is located adjacent to one of the coil assemblies 271e and located on one side of the coil assembly 271e in the circumferential direction D1. In addition, in one of the driving units 270e that is located closest to the Hall sensor 26e, the magnetic pole MPE1 located at one end of the magnet 273e faces the Hall sensor 26e and one of the coils 2710e of the coil assemblies 271e located closest to the Hall sensor 26e.

When a length of each of the magnets 273e in the circumferential direction D1 is Lm, and a radial thickness of each of the magnets 273e is Tm, the following conditions are satisfied: Lm = 15.71 mm; Tm = 0.52 mm; and Lm/Tm = 30.2.

When a length of each of the coils 2710e in the circumferential direction D1 is Lc, and a radial thickness of each of the coils 2710e is Tc, the following conditions are satisfied: Lc = 1.55 mm; Tc = 0.8 mm; and Lc/Tc = 1.9.

When a number of the driving units 270e is Nd, the following condition is satisfied: Nd = 2. When a number of coils facing the magnets 273e in the coil assemblies 271e is Nc, and a number of magnetic poles facing the coil assemblies 271e among the magnets 273e is Nm, the following conditions are satisfied: Nc = 18; Nm = 20; and Nc + Nm = 38.

When the number of coils facing the magnets 273e in the coil assemblies 271e is Nc, the number of magnetic poles facing the coil assemblies 271e among the magnets 273e is Nm, and a number of the Hall sensor 26e is Nh, the following conditions are satisfied: Nc = 18; Nm = 20; Nh = 1; and Nc + Nm + Nh = 39.

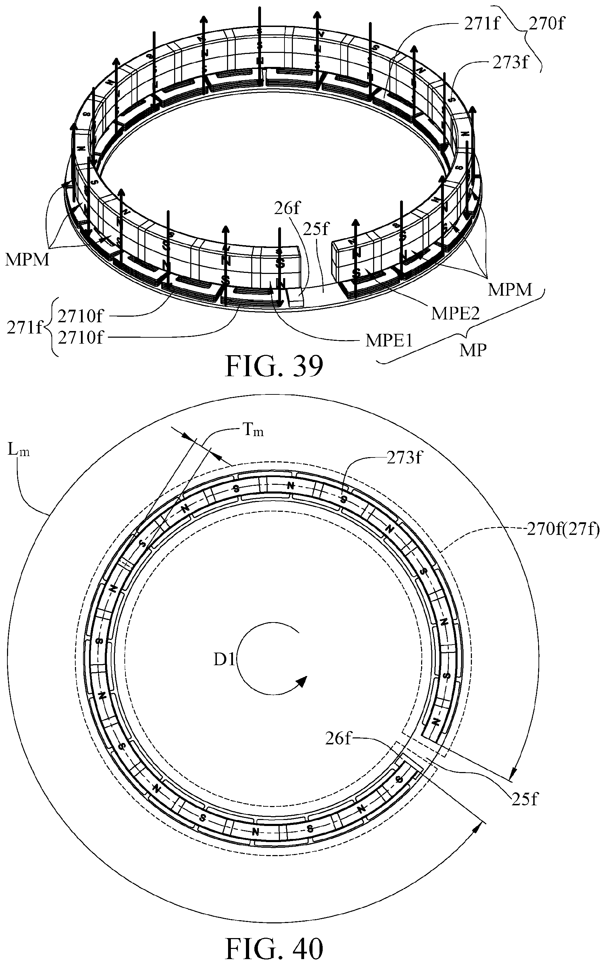

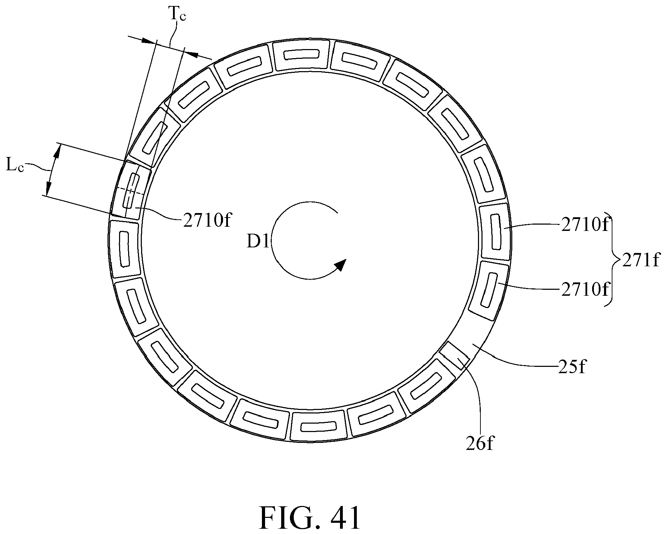

Furthermore, as an additional implementation, please refer to Fig. 39 to Fig. 41. Fig. 39 is a perspective view of a driving mechanism, a Hall sensor and a flexible printed circuit according to another embodiment of the present disclosure, Fig. 40 is a top view of the driving mechanism, the Hall sensor and the flexible printed circuit in Fig. 39, and Fig. 41 is a top view of a coil assembly of the driving mechanism, the Hall sensor and the flexible printed circuit in Fig. 3.

In another configuration of the present disclosure, an adjustable aperture module includes a Hall sensor 26f arranged along the circumferential direction D1. A driving mechanism 27f of the adjustable aperture module includes a driving unit 270f, and the driving unit 270f includes a coil assembly 271f and a magnet 273f that are disposed corresponding to each other. The coil assembly 271f is disposed on a flexible printed circuit 25f and arranged along the circumferential direction D1, and the magnet 273f is disposed on a movable component and arranged along the circumferential direction D1. In addition, the magnet 273f is a sectorial-shaped integrated magnet.

The coil assembly 271f includes nineteen coils 2710f that are arranged along the circumferential direction D1, and the magnet 273f includes a plurality of magnetic poles MP that are arranged along the circumferential direction D1. In detail, the magnet 273f includes twenty magnetic poles MP disposed corresponding to the coil assembly 271f and facing the coil assembly 271f. In addition, each of eighteen magnetic poles MPM of the twenty magnetic poles MP faces two of the coils 2710f of the coil assembly 271f, and the other two magnetic poles MPE1 and MPE2 of the twenty magnetic poles MP located at two ends of the magnet 273f, respectively, each faces one of the coils 2710f of the coil assembly 271f. Fig. 39 shows multiple arrows passing through the magnet 273f to represent the direction of the magnetic field lines of the magnet 273f, but the present disclosure is not limited to the configuration of North (N) and South (S) poles, as well as the direction of the magnetic field lines as shown in Fig. 39.

The Hall sensor 26f is located adjacent to the coil assembly 271f and located on one side of the coil assembly 271f in the circumferential direction D1. In addition, the magnetic pole MPE1 located at one end of the magnet 273f faces the Hall sensor 26f and one of the coils 2710f of the coil assembly 271f located closest to the Hall sensor 26f.

When a length of the magnet 273f in the circumferential direction D1 is Lm, and a radial thickness of the magnet 273f is Tm, the following conditions are satisfied: Lm = 32.39 mm; Tm = 0.52 mm; and Lm/Tm = 62.3.

When a length of each of the coils 2710f in the circumferential direction D1 is Lc, and a radial thickness of each of the coils 2710f is Tc, the following conditions are satisfied: Lc = 1.55 mm; Tc = 0.8 mm; and Lc/Tc = 1.9.

When a number of the driving unit 270f is Nd, the following condition is satisfied: Nd = 1. When a number of coils facing the magnet 273f in the coil assembly 271f is Nc, and a number of magnetic poles facing the coil assembly 271f in the magnet 273f is Nm, the following conditions are satisfied: Nc = 19; Nm = 20; and Nc + Nm = 39.

When the number of coils facing the magnet 273f in the coil assembly 271f is Nc, the number of magnetic poles facing the coil assembly 271f in the magnet 273f is Nm, and a number of the Hall sensor 26f is Nh, the following conditions are satisfied: Nc = 19; Nm = 20; Nh = 1; and Nc + Nm + Nh = 40.

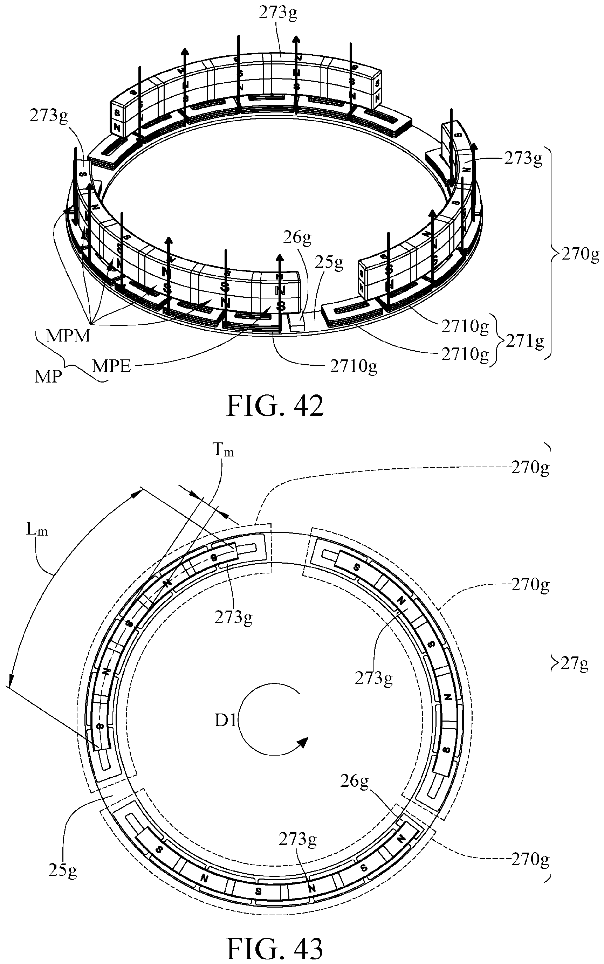

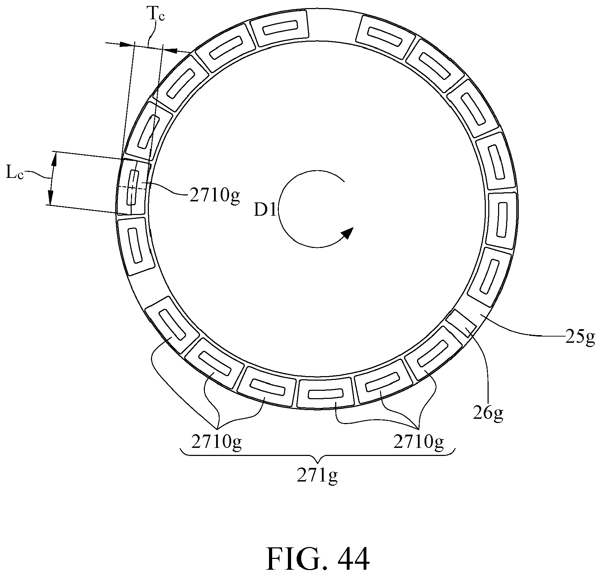

Furthermore, as an additional implementation, please refer to Fig. 42 to Fig. 44. Fig. 42 is a perspective view of a driving mechanism, a Hall sensor and a flexible printed circuit according to another embodiment of the present disclosure, Fig. 43 is a top view of the driving mechanism, the Hall sensor and the flexible printed circuit in Fig. 42, and Fig. 44 is a top view of coil assemblies of the driving mechanism, the Hall sensor and the flexible printed circuit in Fig. 42. In another configuration of the present disclosure, an adjustable aperture module includes a Hall sensor 26g arranged along the circumferential direction D1. A driving mechanism 27g of the adjustable aperture module includes three driving units 270g, and each of the driving units 270g includes a coil assembly 271g and a magnet 273g that are disposed corresponding to each other. The coil assemblies 271g are disposed on a flexible printed circuit 25g and arranged along the circumferential direction D1, and the magnets 273g are disposed on a movable component and arranged along the circumferential direction D1. In addition, each of the magnets 273g is a sectorial-shaped integrated magnet.

Each of the coil assemblies 271g includes six coils 2710g that are arranged along the circumferential direction D1, each of the magnets 273g includes a plurality of magnetic poles MP that are arranged along the circumferential direction D1, and the Hall sensor 26g is located adjacent to one of the coil assemblies 271g and located on one side of the coil assembly 271g in the circumferential direction D1. In detail, in one of the driving units 270g located closest to the Hall sensor 26g, the magnet 273g includes six magnetic poles MP disposed corresponding to the coil assembly 271g and facing the coil assembly 271g. In addition, each of five magnetic poles MPM of the six magnetic poles MP faces two of the coils 2710g of the coil assembly 271g, and the other magnetic pole MPE of the six magnetic poles MP located at one end of the magnet 273g faces the Hall sensor 26g and one of the coils 2710g of the coil assembly 271g located closest to the Hall sensor 26g.

In each of the other two of the driving units 270g, the magnet 273g includes five magnetic poles MP disposed corresponding to the coil assembly 271g and facing the coil assembly 271g. In addition, each of the five magnetic poles MP faces two of the coils 2710g of the coil assembly 271g. Fig. 42 shows multiple arrows passing through the magnets 273g to represent the direction of the magnetic field lines of the magnets 273g, but the present disclosure is not limited to the configuration of North (N) and South (S) poles, as well as the direction of the magnetic field lines as shown in Fig. 42.

When a length of each of the magnets 273g in the circumferential direction D1 is Lm, and a radial thickness of each of the magnets 273g is Tm, the following conditions are satisfied: Lm = 8.11 mm; Tm = 0.52 mm; and Lm/Tm = 15.6.

When a length of each of the coils 2710g in the circumferential direction D1 is Lc, and a radial thickness of each of the coils 2710g is Tc, the following conditions are satisfied: Lc = 1.55 mm; Tc = 0.8 mm; and Lc/Tc = 1.9.

When a number of the driving units 270g is Nd, the following condition is satisfied: Nd = 3. When a number of coils facing the magnets 273g in the coil assemblies 271g is Nc, and a number of magnetic poles facing the coil assemblies 271g among the magnets 273g is Nm, the following conditions are satisfied: Nc = 18; Nm = 16; and Nc + Nm = 34.

When the number of coils facing the magnets 273g in the coil assemblies 271g is Nc, the number of magnetic poles facing the coil assemblies 271g among the magnets 273g is Nm, and a number of the Hall sensor 26g is Nh, the following conditions are satisfied: Nc = 18; Nm = 16; Nh = 1; and Nc + Nm + Nh = 35.

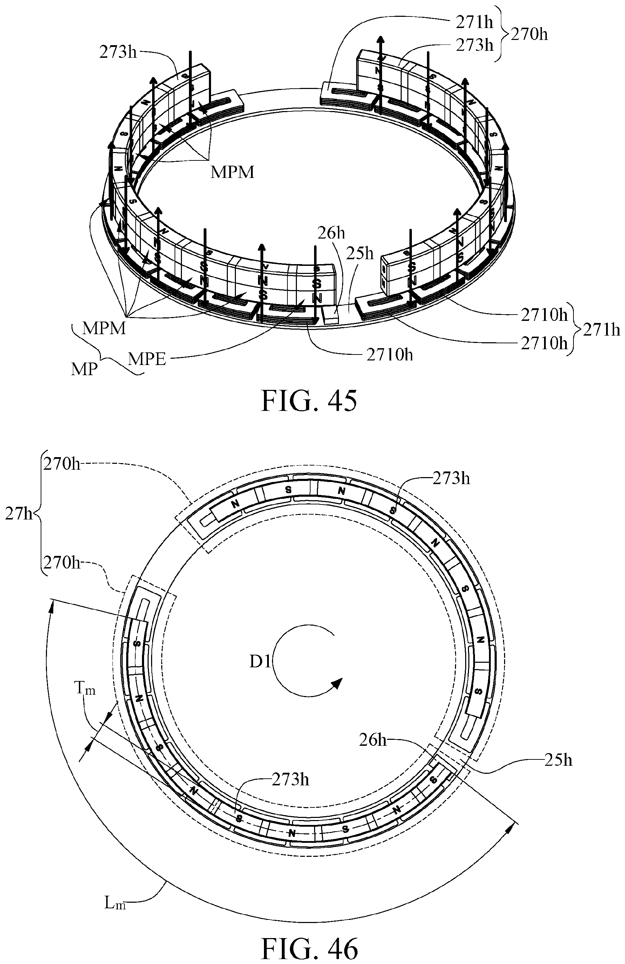

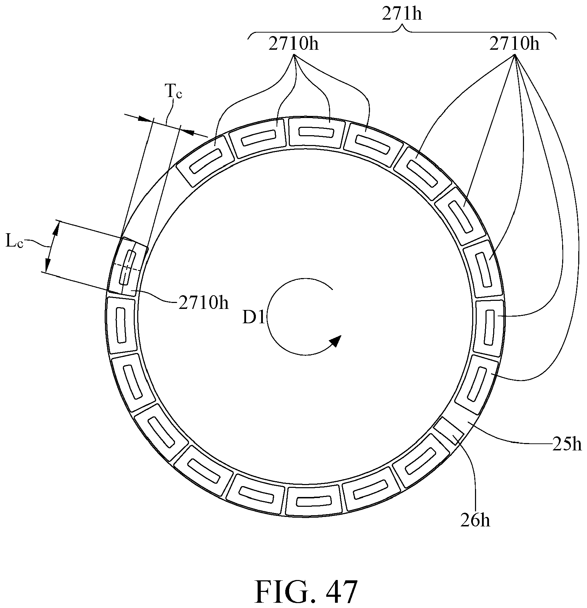

Furthermore, as an additional implementation, please refer to Fig. 45 to Fig. 47. Fig. 45 is a perspective view of a driving mechanism, a Hall sensor and a flexible printed circuit according to another embodiment of the present disclosure, Fig. 46 is a top view of the driving mechanism, the Hall sensor and the flexible printed circuit in Fig. 45, and Fig. 47 is a top view of coil assemblies of the driving mechanism, the Hall sensor and the flexible printed circuit in Fig. 45. In another configuration of the present disclosure, an adjustable aperture module includes a Hall sensor 26h arranged along the circumferential direction D1. A driving mechanism 27h of the adjustable aperture module includes two driving units 270h, and each of the driving units 270h includes a coil assembly 271h and a magnet 273h that are disposed corresponding to each other. The coil assemblies 271h are disposed on a flexible printed circuit 25h and arranged along the circumferential direction D1, and the magnets 273h are disposed on a movable component and arranged along the circumferential direction D1. In addition, each of the magnets 273h is a sectorial-shaped integrated magnet.

Each of the coil assemblies 271h includes nine coils 2710h that are arranged along the circumferential direction D1, each of the magnets 273h includes a plurality of magnetic poles MP that are arranged along the circumferential direction D1, and the Hall sensor 26h is located adjacent to one of the coil assemblies 271h and located on one side of the coil assembly 271h in the circumferential direction D1. In detail, in one of the driving units 270h located closest to the Hall sensor 26h, each of the magnet 273h includes nine magnetic poles MP disposed corresponding to the coil assembly 271h and facing the coil assembly 271h. In addition, each of eight magnetic poles MPM of the nine magnetic poles MP faces two of the coils 2710h of the coil assembly 271h, and the other magnetic pole MPE of the nine magnetic poles MP located at one end of the magnet 273h faces the Hall sensor 26h and one of the coils 2710h of the coil assembly 271h located closest to the Hall sensor 26h.

In the other of the driving units 270h, the magnet 273h includes eight magnetic poles MP disposed corresponding to the coil assembly 271h and facing the coil assembly 271h. In addition, each of the eight magnetic poles MP faces two of the coils 2710h of the coil assembly 271h. Fig. 45 shows multiple arrows passing through the magnet 273h to represent the direction of the magnetic field lines of the magnet 273h, but the present disclosure is not limited to the configuration of North (N) and South (S) poles, as well as the direction of the magnetic field lines as shown in Fig. 45.

When a length of each of the magnets 273h in the circumferential direction D1 is Lm, and a radial thickness of each of the magnets 273h is Tm, the following conditions are satisfied: Lm = 14.41 mm; Tm = 0.52 mm; and Lm/Tm = 27.7.

When a length of each of the coils 2710h in the circumferential direction D1 is Lc, and a radial thickness of each of the coils 2710h is Tc, the following conditions are satisfied: Lc = 1.55 mm; Tc = 0.8 mm; and Lc/Tc = 1.9.

When a number of the driving units 270h is Nd, the following condition is satisfied: Nd = 2. When a number of coils facing the magnets 273h in the coil assemblies 271h is Nc, and a number of magnetic poles facing the coil assemblies 271h among the magnets 273h is Nm, the following conditions are satisfied: Nc = 18; Nm = 17; and Nc + Nm = 35.

When the number of coils facing the magnets 273h in the coil assemblies 271h is Nc, the number of magnetic poles facing the coil assemblies 271h among the magnets 273h is Nm, and a number of the Hall sensor 26h is Nh, the following conditions are satisfied: Nc = 18; Nm = 17; Nh = 1; and Nc + Nm + Nh = 36.

### 3rd Embodiment

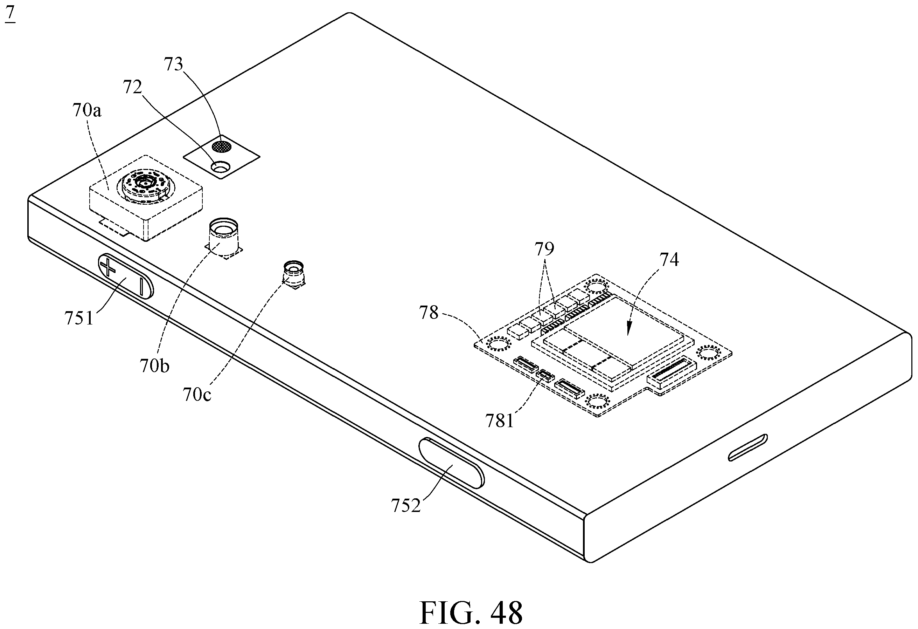

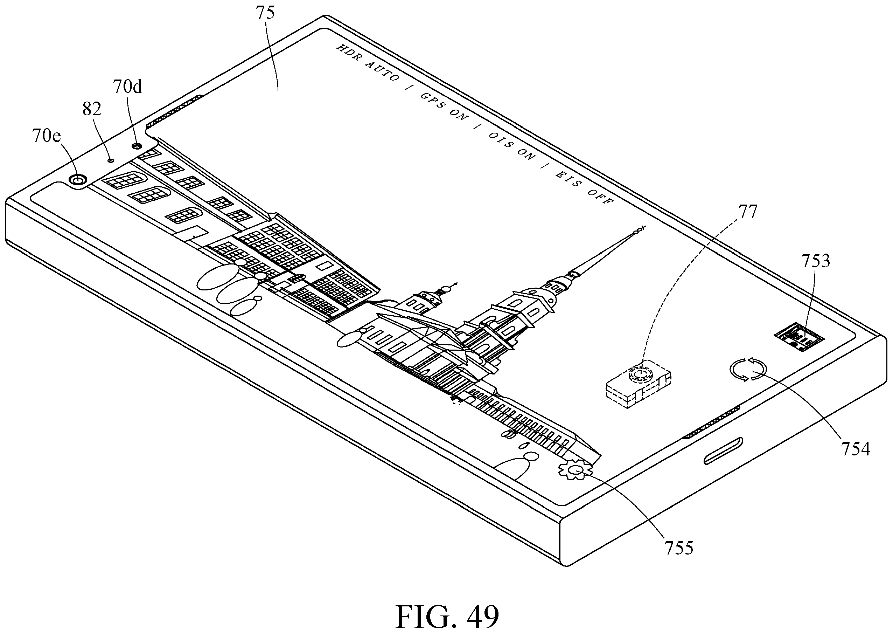

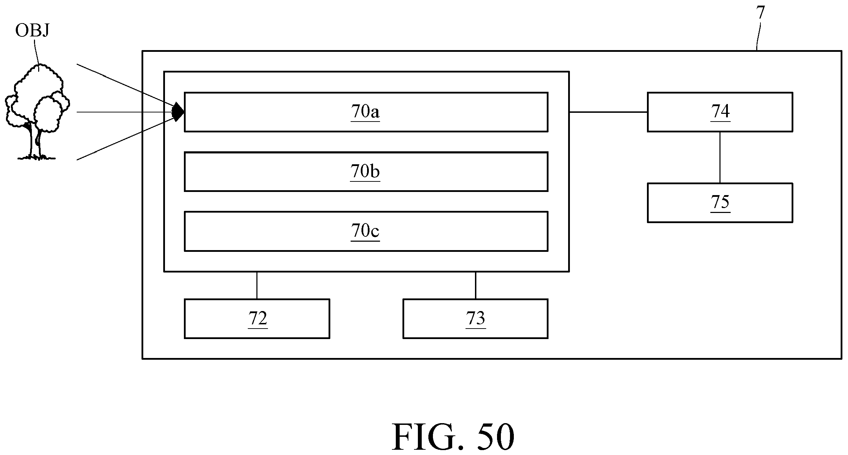

Please refer to Fig. 48 to Fig. 50. Fig. 48 is one perspective view of an electronic device according to the 3rd embodiment of the present disclosure, Fig. 49 is another perspective view of the electronic device in Fig. 48, and Fig. 50 is a block diagram of the electronic device in Fig. 48.

In this embodiment, an electronic device 7 is a mobile device such as a computer, a smartphone, a smart wearable device, a camera drone, a driving recorder and displayer, and the present disclosure is not limited thereto. The electronic device 7 includes a camera module 70a, a camera module 70b, a camera module 70c, a camera module 70d, a camera module 70e, a flash module 72, a focus assist module 73, an image signal processor, a display module 75, an image software processor and a biometric identification device 77. In addition, the camera module 70a includes an imaging lens module and an image sensor, and the imaging lens module includes, for example, the adjustable aperture module 1 as disclosed in the 1st embodiment and an imaging lens. The adjustable aperture module is disposed on an optical axis of the imaging lens, the adjustable aperture module and the imaging lens are arranged along the optical axis, and the image sensor is disposed on an image surface of the imaging lens module. The camera module 70b is a wide-angle camera module, the camera module 70c is a macro-photo camera module, and the camera module 70e is a ToF (time of flight) camera module. In other configurations, the camera module 70a can include, for example, an adjustable aperture module of other configurations of the present disclosure, and the present disclosure is not limited thereto. Moreover, each of the camera module 70b, the camera module 70c, the camera module 70d and the camera module 70e can include, for example, an adjustable aperture module of other configurations of the present disclosure.

The camera module 70a, the camera module 70b and the camera module 70c are disposed on the same side of the electronic device 7. The camera module 70d, the camera module 70e and the display module 75 are disposed on the opposite side of the electronic device 7. The display module 75 can be a user interface, such that the camera module 70d and the camera module 70e can be front-facing cameras of the electronic device 7 for taking selfies, but the present disclosure is not limited thereto.

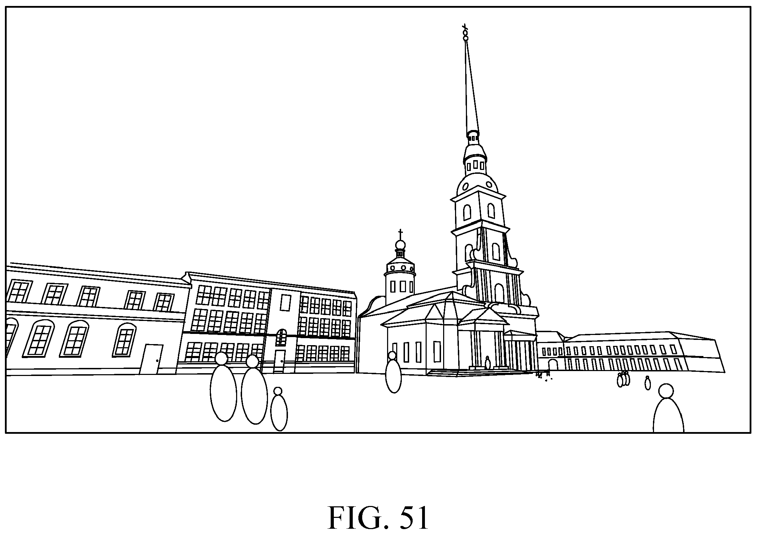

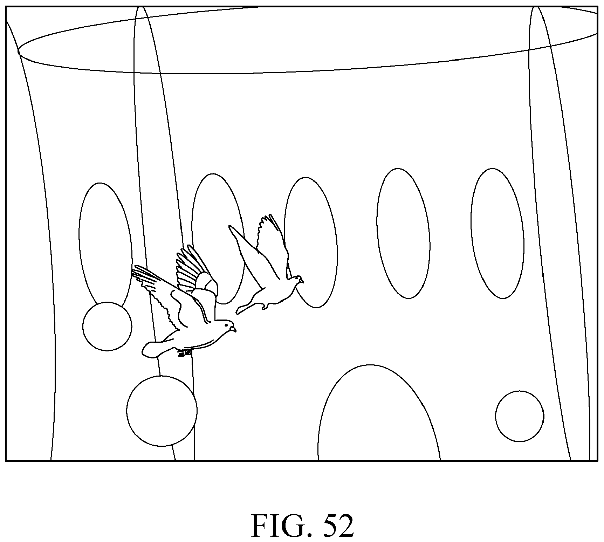

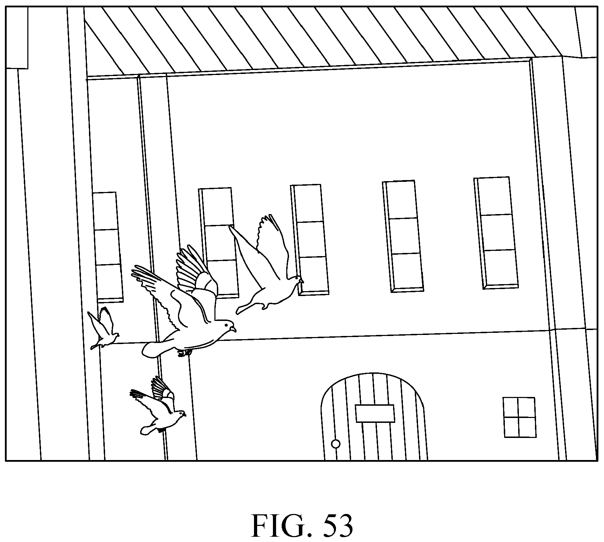

In this embodiment, the camera module 70a, the camera module 70b and the camera module 70c have different fields of view, such that the electronic device 7 can have various magnification ratios so as to meet the requirement of optical zoom functionality. For example, the camera module 70b has a relatively large field of view, and the image captured by the camera module 70b can refer to Fig. 51, which shows an image captured by the electronic device 7 with a wide-angle camera module, and the captured image as shown in Fig. 51 includes the whole cathedral, surrounding buildings and people in front of the cathedral. The captured image as shown in Fig. 51 has a relatively large field of view and depth of view, but it often has a relatively large degree of distortion. The image captured by the camera module 70a having an adjustable aperture module with a relatively small f-number can refer to Fig. 52, and the image captured by the camera module 70a having an adjustable aperture module with a relatively large f-number can refer to Fig. 53. Fig. 52 shows an image captured by the electronic device 7 with a camera module having an adjustable aperture module with an f-number of 1.4, Fig. 53 shows an image captured by the electronic device 7 with a camera module having an adjustable aperture module with an f-number of 5.6, and the captured images as shown in Fig. 52 and Fig. 53 include birds flying in front of the cathedral. As shown in Fig. 52, when the adjustable aperture module of the camera module 70a provides a relatively large light pass aperture, image sensor the image sensor receives more light, but the background in the image is relatively blurry. As shown in Fig. 53, when the adjustable aperture module of the camera module 70a provides a relatively small light pass aperture, the image sensor receives less light, but the background in the image is relatively clear. The captured images as shown in Fig. 52 and Fig. 53 have a relatively small field of view and depth of view, and the camera module 70a having an adjustable aperture module can be used for shooting moving targets. For example, the lens driving unit can drive the lens assembly to quickly and continuously autofocus on the target, such that the captured image of the target would not be blurred due to long focusing distance. When imaging, the camera module 70a having an adjustable aperture module can further perform optical zoom for imaged objects so as to obtain clearer images. In addition, the camera module 70e can determine depth information of the imaged object. In this embodiment, the electronic device 7 includes multiple camera modules 70a, 70b, 70c, 70d, and 70e, but the present disclosure is not limited to the number and arrangement of camera modules.

When a user captures images of an object OBJ, light rays converge in the camera module 70a, the camera module 70b or the camera module 70c to generate images, and the flash module 72 is activated for light supplement. The focus assist module 73 detects the object distance of the imaged object OBJ to achieve fast auto focusing. The image signal processor is configured to optimize the captured image to improve image quality. The light beam emitted from the focus assist module 73 can be either conventional infrared or laser.

In addition, the light rays may converge in the camera module 70d or the camera module 70e to generate images. The electronic device 7 can include a reminder light 82 that can be illuminated to remind the user that the camera module 70d or the camera module 70e is working. The display module 75 can be a touch screen or physical buttons such as a zoom button 751 and a shutter release button 752. The user is able to interact with the display module 75 and the image software processor having multiple functions to capture images and complete image processing. The image processed by the image software processor can be displayed on the display module 75. The user can replay the previously captured image through an image playback button 753 of the display module 75, can choose a suitable camera module for shooting through a camera module switching button 754 of the display module 75, and can properly adjust shooting parameters according to current shooting situations through an integrated menu button 755 of the display module 75.

Further, the electronic device 7 further includes a circuit board 78 and a plurality of electronic components 79 disposed on the circuit board 78. The camera modules 70a, 70b, 70c, 70d, and 70e are electrically connected to the electronic component 79 via connectors 781 on the circuit board 78. The electronic components 79 can include a signal emitting module and can transmit image(s) to other electronic device or a cloud storage via the signal emitting module. The signal emitting module can be a wireless fidelity (WiFi) module, a Bluetooth module, an infrared module, a network service module or an integrated module for transmitting various signals mentioned above, and the present disclosure is not limited thereto.

The electronic components 79 can also include a storage unit, a random access memory for storing image information, a gyroscope, and a position locator for facilitating the navigation or positioning of the electronic device 7. In this embodiment, the image signal processor, the image software processor and the random access memory are integrated into a single chip system 74, but the present disclosure is not limited thereto. In some other embodiments, the electronic components can also be integrated in the camera module or can also be disposed on one of the circuit boards. In addition, the user can use the biometric identification device 77 to turn on and unlock the electronic device 7.

The smartphone in this embodiment is only exemplary for showing the adjustable aperture module, the imaging lens module and the camera module of the present disclosure installed in an electronic device, and the present disclosure is not limited thereto. The adjustable aperture module, the imaging lens module and the camera module can be optionally applied to optical systems with a movable focus. Furthermore, the adjustable aperture module, the imaging lens module and the camera module feature good capability in aberration corrections and high image quality, and can be applied to 3D (three-dimensional) image capturing applications, in products such as digital cameras, mobile devices, digital tablets, smart televisions, network surveillance devices, dashboard cameras, vehicle backup cameras, multi-camera devices, image recognition systems, motion sensing input devices, wearable devices and other electronic imaging devices. The foregoing description, for the purpose of explanation, has been described with reference to specific embodiments. It is to be noted that the present disclosure shows different data of the different embodiments; however, the data of the different embodiments are obtained from experiments. The embodiments were chosen and described in order to best explain the principles of the disclosure and its practical applications, to thereby enable others skilled in the art to best utilize the disclosure and various embodiments with various modifications as are suited to the particular use contemplated. The embodiments depicted above and the appended drawings are exemplary and are not intended to be exhaustive or to limit the scope of the present disclosure to the precise forms disclosed. Many modifications and variations are possible in view of the above teachings.

**Claims**

1. An adjustable aperture module (1) comprising:

   a blade assembly (11) comprising at least two light-blocking blades (111) overlapping one another in a circumferential direction (D1) surrounding a central axis (CL) of the adjustable aperture module (1) and together forming a light pass aperture (LPH), and an aperture size of the light pass aperture (LPH) being adjustable;
   a fixed component (12) connected to the blade assembly (11);
   a movable component (13) connected to the blade assembly (11) and disposed corresponding to the fixed component (12); and
   a driving mechanism (17) configured to rotate the movable component (13) in the circumferential direction (D1) relative to the fixed component (12) so as to move the blade assembly (11) for adjusting the aperture size of the light pass aperture (LPH), and the driving mechanism (17) comprising:

      at least one coil assembly (171) comprising at least two coils (1710); and
      at least one magnet (173) disposed on the movable component (13), and the at least one magnet (173) comprising:
      at least one magnetic pole (MP) disposed corresponding to the at least one coil assembly (171) and facing at least two coils (1710) of the at least one coil assembly (171);

   wherein the at least one coil assembly (171) is arranged along the circumferential direction (D1), and the at least one magnet (173) is arranged along the circumferential direction (D1);
   wherein a length of each of the at least one magnet (173) in the circumferential direction (D1) is Lm, a radial thickness of each of the at least one magnet (173) is Tm, and the following condition is satisfied:

   $$1.5 < Lm/Tm < 80.$$

2. The adjustable aperture module (1) of claim 1, wherein a length of each of the at least two coils (1710) in the circumferential direction (D1) is Lc, a radial thickness of each of the at least two coils (1710) is Tc, and the following condition is satisfied:

   $$1 < Lc/Tc < 15.$$

3. The adjustable aperture module (1) of claim 1, wherein a number of coils facing the at least one magnet (173) in the at least one coil assembly (171) is Nc, a number of magnetic poles facing the at least one coil assembly (171) among the at least one magnet (173) is Nm, and the following condition is satisfied:

$$Nc + Nm \geq 5.$$

4. The adjustable aperture module (1) of claim 1, wherein the driving mechanism (17) further comprises at least one driving unit (170), and each of the at least one driving unit (170) comprises one of the at least one coil assembly (171) and one of the at least one magnet (173).

5. The adjustable aperture module (1) of claim 4, wherein a number of the at least one driving unit (170) is Nd, and the following condition is satisfied:

$$0 < Nd < 20.$$

6. The adjustable aperture module (1) of claim 1, wherein the movable component (13) further comprises a mounting structure (132), and the at least one magnet (173) is disposed on the mounting structure (132).

7. The adjustable aperture module (1) of claim 1, further comprising:

   a flexible printed circuit (15), wherein the at least one coil assembly (171) of the driving mechanism (17) is disposed on the flexible printed circuit (15); and
   a Hall sensor (16) located on one side of the at least one coil assembly (171) in the circumferential direction (D1) and disposed on the flexible printed circuit (15).

8. The adjustable aperture module (1) of claim 7, wherein the at least one magnetic pole (MP) comprises at least two magnetic poles (MP1, MP2, MP3), and one of the at least two magnetic poles (MP1) faces two coils (1710) of the at least one coil assembly (171).

9. The adjustable aperture module (2) of claim 8, wherein another of the at least two magnetic poles (MP2) faces the Hall sensor (26) and one coil (2710) of the at least one coil assembly (271) located closest to the Hall sensor (26).

10. An imaging lens module comprising:

the adjustable aperture module (1) of claim 1; and
an imaging lens, wherein the adjustable aperture module (1) is disposed on an optical axis of the imaging lens, and the adjustable aperture module (1) and the imaging lens are arranged along the optical axis.

11. A camera module (70a) comprising:

   the imaging lens module of claim 10; and
   an image sensor disposed on an image surface of the imaging lens module.

12. An electronic device (7) comprising:
    the camera module (70a) of claim 11.

13. An adjustable aperture module (2) comprising:

   a blade assembly (21) comprising at least two light-blocking blades (211) overlapping one another in a circumferential direction (D1) surrounding a central axis (CL) of the adjustable aperture module (2) and together forming a light pass aperture (LPH), and an aperture size of the light pass aperture (LPH) being adjustable;
   a fixed component (22) connected to the blade assembly (21);
   a movable component (23) connected to the blade assembly (21) and disposed corresponding to the fixed component (22);
   a driving mechanism (27) configured to rotate the movable component (23) in the circumferential direction (D1) relative to the fixed component (22) so as to move the blade assembly (21) for adjusting the aperture size of the light pass aperture (LPH), and the driving mechanism (27) comprising:

      at least one coil assembly (271) comprising at least two coils (2710); and
      at least one magnet (273) disposed on the movable component (23), and the at least one magnet (273) comprising:
      at least two magnetic poles (MP), comprises:

         a first magnetic pole (MP1) disposed corresponding to the at least one coil assembly (271) and facing two coils (2710) of the at least one coil assembly (271); and
         a second magnetic pole (MP2) disposed corresponding to the at least one coil assembly (271) and facing one coil (2710) of the at least one coil assembly (271); and

at least one Hall sensor (26) facing the second magnetic pole (MP2) and configured to detect changes in a magnetic field around the second magnetic pole (MP);

wherein the at least one coil assembly (271) is arranged along the circumferential direction (D1), the at least one magnet (273) is arranged along the circumferential direction (D1), and the at least one Hall sensor (26) is arranged along the circumferential direction (D1);

wherein a length of each of the at least one magnet (273) in the circumferential direction (D1) is Lm, a radial thickness of each of the at least one magnet (273) is Tm, and the following condition is satisfied:

$$1.5 < Lm/Tm < 80.$$

14. The adjustable aperture module (2) of claim 13, wherein a length of each of the at least two coils (2710) in the circumferential direction (D1) is Lc, a radial thickness of each of the at least two coils (2710) is Tc, and the following condition is satisfied:

$$1 < Lc/Tc < 15.$$

15. The adjustable aperture module (2) of claim 13, wherein a number of coils facing the at least one magnet (273) in the at least one coil assembly (271) is Nc, a number of magnetic poles facing the at least one coil assembly (271) among the at least one magnet (273) is Nm, a number of the at least one Hall sensor (26) is Nh, and the following condition is satisfied:

$$Nc + Nm + Nh \geq 6.$$

16. The adjustable aperture module (2) of claim 13, wherein the driving mechanism (27) further comprises at least one driving unit (270), and each of the at least one driving unit (270) comprises one of the at least one coil assembly (271) and one of the at least one magnet (273).

17. The adjustable aperture module (2) of claim 16, wherein a number of the at least one driving unit (270) is Nd, and the following condition is satisfied:

$$1 < Nd < 20.$$

18. The adjustable aperture module (2) of claim 13, wherein the movable component (23) further comprises a mounting structure (232), and the at least one magnet (273) is disposed on the mounting structure (232).

19. The adjustable aperture module (2) of claim 13, further comprising:

a flexible printed circuit (25), wherein the at least one coil assembly (271) of the driving mechanism (27) is disposed on the flexible printed circuit (25).

20. The adjustable aperture module (2) of claim 19, wherein the at least one Hall sensor (26) is located on one side of the at least one coil assembly (271) in the circumferential direction (D1) and disposed on the flexible printed circuit (25).

21. The adjustable aperture module (2) of claim 13, wherein the second magnetic pole (MP2) faces the at least one Hall sensor (26) and one coil of the at least one coil assembly (271) located closest to the at least one Hall sensor (26).

<u>1</u>

11

13

12

FIG. 1

FIG. 2

1

FIG. 3

FIG. 4

FIG. 5

FIG. 6

FIG. 7

FIG. 8

FIG. 9

FIG. 10

FIG. 11

FIG. 12

FIG. 13

171c ⎫ 170c
173c ⎭

16c    15c

MP

MP

171c ⎰ 1710c
     ⎱ 1710c

## FIG. 14

T_m

L_m

173c

170c(17c)

D1

15c

16c

## FIG. 15

FIG. 16

2

21

23

22

FIG. 17

FIG. 18

2

22

25

273

273

273

232

232

232

23

24

LPH

211
21
211

G1

G1

CL

FIG. 19

FIG. 20

FIG. 21

FIG. 22

FIG. 23

FIG. 24

FIG. 25

FIG. 26

25b
26b
273b / 270b
271b
MPM
2710b
MPM
MP / MPE
2710b / 271b
2710b

**FIG. 27**

270b
273b
27b
270b
26b
Tm
D1
26b
273b
25b
Lm

**FIG. 28**

FIG. 29

FIG. 30

FIG. 31

FIG. 32

273d

273d

273d

273d

270d

MPE1    MPM    MPE2    25d    271d

MP

2710d

2710d    MPE2

MPE1    26d

## FIG. 33

$T_m$

270d

$L_m$

270d

27d

273d    25d

273d

D1

270d

273d

26d

270d

## FIG. 34

FIG. 35

FIG. 36

FIG. 37

FIG. 38

271f 270f
273f
26f
25f
MPM
MPM
271f 2710f
2710f
MPE2
MPE1
MP

FIG. 39

$T_m$
$L_m$
273f
270f(27f)
D1
26f
25f

FIG. 40

FIG. 41

273g

273g

273g

270g

26g

25g

2710g

2710g

2710g

2710g

271g

MPM

MPE

MP

## FIG. 42

$T_m$

270g

$L_m$

270g

273g

27g

273g

D1

273g

26g

25g

273g

270g

## FIG. 43

FIG. 44

FIG. 45

FIG. 46

FIG. 47

FIG. 48

FIG. 49

EP 4 462 184 A1

OBJ

70a

70b

70c

72

73

74

75

7

FIG. 50

FIG. 51

FIG. 52

FIG. 53

Europäisches
Patentamt

European
Patent Office

Office européen
des brevets

# EUROPEAN SEARCH REPORT

**Application Number**

EP 23 21 2911

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/143135 A1 (HUAWEI TECH CO LTD [CN]) 7 July 2022 (2022-07-07) | 1-21 | INV. G03B9/06 G02B5/00 G03B30/00 |
| Y | * paragraphs [0120] - [0159]; figures 5, 8, 9, 16, 17, 18, 20 * ----- | 7,9,19, 20 | |
| X | US 4 378 146 A (SUZUKI SHOJI [JP] ET AL) 29 March 1983 (1983-03-29) * columns 3-5; figures 2,3,5,8 * ----- | 1-4,6, 10,14-18 | |
| Y | US 2020/028998 A1 (JUN JAE WOO [KR]) 23 January 2020 (2020-01-23) * paragraph [0105]; figures 3A, 3B * ----- | 7,9,19, 20 | |

**TECHNICAL FIELDS SEARCHED (IPC)**

G03B
G02B

The present search report has been drawn up for all claims

| Place of search | Date of completion of the search | Examiner |
|---|---|---|
| Munich | 7 May 2024 | Rückerl, Ralph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2911

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2024

| Patent document cited in search report | | Publication date | Patent family member(s) | | Publication date |
|---|---|---|---|---|---|
| WO 2022143135 | A1 | 07-07-2022 | CN | 114726977 A | 08-07-2022 |
| | | | CN | 115989679 A | 18-04-2023 |
| | | | EP | 4254931 A1 | 04-10-2023 |
| | | | US | 2024061317 A1 | 22-02-2024 |
| | | | WO | 2022143135 A1 | 07-07-2022 |
| US 4378146 | A | 29-03-1983 | NONE | | |
| US 2020028998 | A1 | 23-01-2020 | CN | 110737146 A | 31-01-2020 |
| | | | CN | 209911736 U | 07-01-2020 |
| | | | KR | 20200009823 A | 30-01-2020 |
| | | | US | 2020028998 A1 | 23-01-2020 |

EPO FORM P0459

For more details about this annex : see Official Journal of the European Patent Office, No. 12/82